# EUROPEAN PATENT APPLICATION

(11) **EP 4 765 634 A1**
(43) Date of publication of application: **24.06.2026**
(21) Application number: 25213943.1
(22) Date of filing: 06.11.2025
(51) Int. Cl.: H03H 7/46, H04B 1/00

(54) **RADIO FREQUENCY COMMUNICATION CIRCUITS AND METHODS**

(30) Priority: 20.12.2024 US 202418988995
(71) Applicant: INTEL Corporation, Santa Clara, CA 95054 (US)
(72) Inventor: MOHAMMADI, Elham, Portland, 97229 (US); ROZENFELD, Yuri, 3542003 Haifa (IL); DEGANI, Ofir, 22801 Nes-Ammin (IL); NATARAJAN, Karthik, Portland, 97229 (US); AVRAHAM, Oren Ezra, 5405220 Givat Shmuel (IL); BEN-BASSAT, Assaf, 3440306 Haifa (IL)
(74) Representative: Viering, Jentschura & Partner mbB Patent- und Rechtsanwälte

(57) **Abstract**

An apparatus may include: a common input terminal; a first inductor and a second inductor, each coupled to the common input terminal, wherein the first inductor and the second inductor are disposed in an electromagnetic coupling configuration; a lower frequency band output terminal coupled to the first inductor; a higher frequency band output terminal coupled to the second inductor; wherein the first inductor and the second inductor are to separate signals received from the common input terminal into the lower and the higher frequency band output terminals based on frequencies of the received signals. An apparatus may include: a first transformer magnetically couple a signal within a first frequency band and generate a first magnetic field with a first orientation; and a second transformer configured to magnetically couple a signal within a second frequency band that is different from the first frequency band.

## Description

### Background

In radio communication networks in accordance with many radio communication technologies, such as Wireless LAN (also referred to as Wi-Fi), Bluetooth, Fourth Generation (LTE), and Fifth Generation (5G) New Radio (NR), various methods are employed to provide wireless data transfer with desired efficiency, speed, and reliability. These networks require robust design and implementation of radio frequency (RF) components to achieve desired performance characteristics, including low power consumption, high bandwidth, and minimal interference. Among the components that enable wireless communication, RF communication circuits, specifically dual-band transformers and diplexers, are essential for enabling simultaneous transmission across multiple frequency bands.

Diplexer circuits may be considered as key elements in the RF front-end, which may be configured for isolating and directing signals to different frequency bands, thereby supporting multi-band operation in wireless communication devices. In this constellation, dual band transformers and associated diplexers may complement each other's operation since dual band transformers may facilitate the use of separate transmit chains by handling high-band and low-band frequencies concurrently.

### Brief Description of the Drawings

In the drawings, like reference characters generally refer to the same parts throughout the different views. The drawings are not necessarily to scale, emphasis instead generally being placed upon illustrating the principles described herein. In the following description, various aspects are described with reference to the following drawings, in which:
FIGs. 1 and 2 depict a general network and device architecture for wireless communications and/or sensing operations;
FIG. 3 shows an exemplary illustration of various communication elements of an apparatus for a wireless communication device;
FIG. 4 shows an exemplary illustration of a transmit path of an RF transceiver configured for dual-band operation;
FIG. 5 shows an illustrative example of the diplexer circuit in accordance with various aspects described herein;
FIG. 6 shows an illustrative example of a miniaturized diplexer;
FIG. 7 shows an exemplary illustration of a diplexer including the diplexer circuit;
FIG. 8 shows a schematic example of a diplexer circuit designed for operation across two distinct frequency bands;
FIGs. 9A-9C illustrate an example of the performance characteristics of the diplexer circuit designed with coupled inductors;
FIGs. 10A-10C illustrate a schematic example of the transmission circuit as described herein;
FIG. 11 shows an exemplary illustration of a transmission circuit in accordance with various aspects described herein;
FIGs. 12A-B illustrate measured output levels at an RF transceiver in accordance with aspects described herein;
FIGs. 13A-C illustrate second harmonic (H2), third harmonic (H3), and fourth harmonic (H4) power levels at the antenna at an RF transceiver in accordance with aspects described herein;
FIG. 14 shows an example of a method;
FIG. 15 shows an example of a method.

### Description

The following detailed description refers to the accompanying drawings that show, by way of illustration, exemplary details and aspects in which aspects described herein may be practiced.

Diplexers are typically designed to facilitate signal separation by employing two distinct filters, each tuned to pass signals in a specific frequency band while rejecting signals in the other band. Achieving optimal performance in diplexers may entail several critical design challenges, such as the following: i) insertion loss and rejection referring to maintaining low insertion loss while achieving the desired level of signal rejection within each filter band is essential to preserve signal integrity and minimize power loss; ii) path isolation referring to ensuring effective isolation between the two signal paths is crucial to avoid interference and maintain reliable operation; and component size and layout referring to increasing the size of individual components or increasing the physical distance between them can help achieve the desired performance metrics. However, such approaches can lead to larger circuit footprints, which may be undesirable in modern compact and cost-sensitive devices.

Traditional diplexer designs may employ a variety of techniques, such as multilayer technologies in which multiple layers are used with specified distances between them as a common approach to mitigate coupling effects and improve isolation, which relies on the physical separation provided by multilayer structures. Another diplexer design may be separated filter design by designing two separate filters and placing them at a defined distance apart, which can effectively reduce coupling between the signal paths. Again, this technique relies on spatial separation to achieve the desired isolation. A further diplexer design may include inductor design modifications by increasing the number of turns in inductors that has been employed to minimize their coupling with other circuit elements, intending to achieve better isolation through inductor geometry adjustments.

However, these existing solutions may exhibit various shortcomings. For example, the use of multilayer technologies often requires multiple chips in the RF front-end, which can reduce design flexibility and introduce complications in integrating the diplexer with other components, such as switches and couplers. Additionally, commercially available multilayer technologies may not cater to custom designs, leading to increased costs and limited accessibility. Furthermore, approaches relying on larger components or greater separation distances inherently increase the overall circuit area, which is contrary to the trend of miniaturization in modem electronic devices. Moreover, the design strategies for isolation and coupling reduction can often constrain the available design parameters, limiting the possibility of exploring all feasible configurations. Additionally, increasing the number of turns in inductors, while potentially reducing coupling, can degrade the quality factor of the inductors, resulting in higher insertion loss, negatively impacting the overall performance of the diplexer.

In accordance with various aspects described herein, a diplexer circuit address some of these shortcoming with a specific design. Such diplexer circuit may allow the integration of all front-end components, including the diplexer, and which may also include switches and couplers, on a single chip to reduce complexity and enhance design flexibility. In some aspects, such diplexer circuit may minimize the physical footprint of the diplexer and may achieve a significant reduction in area, leading to cost-effective implementations suitable for modem devices. In some aspects, such diplexer circuit may enhance Key Performance Indicators (KPIs), by adding an additional degree of freedom to the diplexer configuration, while enabling improved performance metrics such as insertion loss, rejection, and isolation.

As previously indicated, dual-band operation, wherein two separate transmit chains handle high band and low band frequencies concurrently, is an established approach to enable multi band operation functionality. While effective in providing the desired operational capability, this approach may introduce certain drawbacks, particularly in terms of area efficiency and signal integrity. First, the use of separate transmit chains for each band may inherently result in a total circuit area that is at least as large as the sum of the areas occupied by the individual chains. Such a design may lead to increased silicon consumption, which directly impacts manufacturing costs, particularly for integrated circuit (IC) implementations where area efficiency is critical. Second, significant power leakage may occur between the two chains during concurrent operation. This leakage can degrade the performance of the adjacent chain and adversely affect the RF spectral cleanliness. Degraded RF spectral cleanliness may result in interference between the two bands, leading to performance degradation. Furthermore, such interference can violate regulatory limits imposed on spectral purity, posing compliance challenges.

Traditionally, with respect to the issues of power leakage and area inefficiency, several approaches are present. For example, a sufficient "buffer zone" can be introduced between the two frequency bands. By allocating additional physical separation within the circuit layout, this approach can reduce the coupling between the two bands. Additionally, or alternatively, transmit power of one or both chains can be limited to minimize the level of interference. By operating at reduced power levels, the system can mitigate the coupling effects between the bands. In some cases, on-chip filtering techniques can be used to reduce harmonic coupling between the two chains. Filters designed specifically for each band can attenuate unwanted harmonics and reduce interference.

These traditional approaches may be associated with certain drawbacks that can limit their effectiveness, although they provide a partial mitigation. While buffer zones can reduce interference, they are inherently area-inefficient. Allocating additional space within an integrated circuit increases the total silicon area required, leading to higher manufacturing costs. In applications where space is limited, this approach is not desirable. Limiting the transmit power, although effective in reducing interference, reduces the overall transmission range of the communication system. Reduced transmission range directly can impact the system's ability to maintain robust connections, particularly in environments where signal propagation is already challenging. On-chip filters, while addressing interference to some extent, introduce additional complexity to the circuit design. These filters can occupy significant silicon area and thus negatively impact product cost. Moreover, the insertion of filters in the signal path can affect critical performance metrics, such as power consumption and overall system efficiency.

In accordance with various aspects described herein, a transmission circuit can be configured to address at least some of these limitations by introducing an anti-symmetric front-end (FE) structure. This structure may operate in a concurrent (simultaneous dual-band) transmit mode and may be configured to cancel out harmonics coupled from one band to the other at various or any power level and can also address the total area requirement, which is currently at least as large as the sum of the areas occupied by two separate transmit chains for high-band and low-band operation, and significant power leakage between the two chains which can cause performance degradation and compromises RF spectral cleanliness, potentially violating regulatory limits.

The apparatuses and methods described herein may utilize or be related to radio communication technologies. While some examples may refer to specific radio communication technologies, the examples provided herein may be similarly applied to various other radio communication technologies, both existing and not yet formulated, particularly in cases where such radio communication technologies share similar features as disclosed regarding the following examples. Various exemplary radio communication technologies that the apparatuses and methods described herein may utilize include, but are not limited to: a Global System for Mobile Communications ("GSM") radio communication technology, a General Packet Radio Service ("GPRS") radio communication technology, an Enhanced Data Rates for GSM Evolution ("EDGE") radio communication technology, and/or a Third Generation Partnership Project ("3GPP") radio communication technology, for example Universal Mobile Telecommunications System ("UMTS"), Freedom of Multimedia Access ("FOMA"), 3GPP Long Term Evolution ("LTE"), 3GPP Long Term Evolution Advanced ("LTE Advanced"), Code division multiple access 2000 ("CDMA2000"), Cellular Digital Packet Data ("CDPD"), Mobitex, Third Generation (3G), Circuit Switched Data ("CSD"), High-Speed Circuit-Switched Data ("HSCSD"), Universal Mobile Telecommunications System ("Third Generation") ("UMTS (3G)"), Wideband Code Division Multiple Access (Universal Mobile Telecommunications System) ("W-CDMA (UMTS)"), High Speed Packet Access ("HSPA"), High-Speed Downlink Packet Access ("HSDPA"), High-Speed Uplink Packet Access ("HSUPA"), High Speed Packet Access Plus ("HSPA+"), Universal Mobile Telecommunications System-Time-Division Duplex ("UMTS-TDD"), Time Division-Code Division Multiple Access ("TD-CDMA"), Time Division-Synchronous Code Division Multiple Access ("TD-CDMA"), 3rd Generation Partnership Project Release 8 (Pre-4th Generation) ("3GPP Rel. 8 (Pre-4G)"), 3GPP Rel. 9 (3rd Generation Partnership Project Release 9), 3GPP Rel. 10 (3rd Generation Partnership Project Release 10) , 3GPP Rel. 11 (3rd Generation Partnership Project Release 11), 3GPP Rel. 12 (3rd Generation Partnership Project Release 12), 3GPP Rel. 13 (3rd Generation Partnership Project Release 13), 3GPP Rel. 14 (3rd Generation Partnership Project Release 14), 3GPP Rel. 15 (3rd Generation Partnership Project Release 15), 3GPP Rel. 16 (3rd Generation Partnership Project Release 16), 3GPP Rel. 17 (3rd Generation Partnership Project Release 17), 3GPP Rel. 18 (3rd Generation Partnership Project Release 18), 3GPP 4G, 3GPP LTE Extra, LTE-Advanced Pro, LTE Licensed-Assisted Access ("LAA"), MuLTEfire, UMTS Terrestrial Radio Access ("UTRA"), Evolved UMTS Terrestrial Radio Access ("E-UTRA"), Long Term Evolution Advanced (4th Generation) ("LTE Advanced (4G)"), cdmaOne ("2G"), Code division multiple access 2000 (Third generation) ("CDMA2000 (3G)"), Evolution-Data Optimized or Evolution-Data Only ("EV-DO"), Advanced Mobile Phone System (1st Generation) ("AMPS (1G)"), Total Access Communication arrangement/Extended Total Access Communication arrangement ("TACS/ETACS"), Digital AMPS (2nd Generation) ("D-AMPS (2G)"), Push-to-talk ("PTT"), Mobile Telephone System ("MTS"), Improved Mobile Telephone System ("IMTS"), Advanced Mobile Telephone System ("AMTS"), OLT (Norwegian for Offentlig Landmobil Telefoni, Public Land Mobile Telephony), MTD (Swedish abbreviation for Mobiltelefonisystem D, or Mobile telephony system D), Public Automated Land Mobile ("Autotel/PALM"), ARP (Finnish for Autoradiopuhelin, "car radio phone"), NMT (Nordic Mobile Telephony), High capacity version of NTT (Nippon Telegraph and Telephone) ("Hicap"), Cellular Digital Packet Data ("CDPD"), Mobitex, DataTAC, Integrated Digital Enhanced Network ("iDEN"), Personal Digital Cellular ("PDC"), Circuit Switched Data ("CSD"), Personal Handy-phone System ("PHS"), Wideband Integrated Digital Enhanced Network ("WiDEN"), iBurst, Unlicensed Mobile Access ("UMA"), also referred to as also referred to as 3GPP Generic Access Network, or GAN standard), Zigbee, Bluetooth^{®}, Wireless Gigabit Alliance ("WiGig") standard, mmWave standards in general (wireless systems operating at 10-300 GHz and above such as WiGig, IEEE 802.11ad, IEEE 802.11ay, etc.), technologies operating above 300 GHz and THz bands, (3GPP/LTE based or IEEE 802.11p and other) Vehicle-to-Vehicle ("V2V") and Vehicle-to-X ("V2X") and Vehicle-to-Infrastructure ("V2I") and Infrastructure-to-Vehicle ("I2V") communication technologies, 3GPP cellular V2X, DSRC (Dedicated Short Range Communications) communication arrangements such as Intelligent-Transport-Systems, and other existing, developing, or future radio communication technologies.

The apparatuses and methods described herein may use such radio communication technologies according to various spectrum management schemes, including, but not limited to, dedicated licensed spectrum, unlicensed spectrum, (licensed) shared spectrum (such as LSA = Licensed Shared Access in 2.3-2.4 GHz, 3.4-3.6 GHz, 3.6-3.8 GHz and further frequencies and SAS = Spectrum Access System in 3.55-3.7 GHz and further frequencies), and may use various spectrum bands including, but not limited to, IMT (International Mobile Telecommunications) spectrum (including 450-470 MHz, 690-960 MHz, 1710-2025 MHz, 2110-2200 MHz, 2300-2400 MHz, 2500-2690 MHz, 698-790 MHz, 610-790 MHz, 3400-3600 MHz, etc., where some bands may be limited to specific region(s) and/or countries), IMT-advanced spectrum, IMT-2020 spectrum (expected to include 3600-3800 MHz, 3.5 GHz bands, 600 MHz bands, bands within the 24.25-86 GHz range, etc.), spectrum made available under FCC's "Spectrum Frontier" 4G initiative (including 27.5-28.35 GHz, 29.1-29.25 GHz, 31-31.3 GHz, 37-38.6 GHz, 38.6-40 GHz, 42-42.5 GHz, 47-64 GHz, 64-71 GHz, 61-76 GHz, 81-86 GHz and 92-94 GHz, etc.), the ITS (Intelligent Transport Systems) band of 4.9 GHz (typically 4.85-5.925 GHz) and 63-64 GHz, bands currently allocated to WiGig such as WiGig Band 1 (57.24-59.40 GHz), WiGig Band 2 (59.40-61.56 GHz) and WiGig Band 3 (61.56-63.72 GHz) and WiGig Band 4 (63.72-65.88 GHz), the 60.2 GHz-71 GHz band, any band between 65.88 GHz and 61 GHz, bands currently allocated to automotive radar applications such as 66-81 GHz, and future bands including 94-300 GHz and above. Furthermore, the apparatuses and methods described herein can also employ radio communication technologies on a secondary basis on bands such as the TV White Space bands (typically below 690 MHz) where e.g. the 400 MHz and 600 MHz bands are prospective candidates. Besides cellular applications, specific applications for vertical markets may be addressed such as PMSE (Program Making and Special Events), medical, health, surgery, automotive, low-latency, drones, etc. applications. Furthermore, the apparatuses and methods described herein may also use radio communication technologies with a hierarchical application, such as by introducing a hierarchical prioritization of usage for different types of users (e.g., low/medium/high priority, etc.), based on a prioritized access to the spectrum e.g., with highest priority to tier-1 users, followed by tier-2, then tier-3, etc. users, etc. The apparatuses and methods described herein can also use radio communication technologies with different Single Carrier or OFDM flavors (CP-OFDM, SC-FDMA, SC-OFDM, filter bank-based multicarrier (FBMC), OFDMA, etc.) and e.g. 3GPP NR (New Radio), which can include allocating the OFDM carrier data bit vectors to the corresponding symbol resources.

As described herein, radio communication technologies may be classified as one of a Short Range radio communication technology or Cellular Wide Area radio communication technology. Short Range radio communication technologies may include Bluetooth, WLAN (e.g., according to any IEEE 802.11 standard), and other similar radio communication technologies. Cellular Wide Area radio communication technologies may include Global System for Mobile Communications ("GSM"), Code Division Multiple Access 2000 ("CDMA2000"), Universal Mobile Telecommunications System ("UMTS"), Long Term Evolution ("LTE"), General Packet Radio Service ("GPRS"), Evolution-Data Optimized ("EV-DO"), Enhanced Data Rates for GSM Evolution ("EDGE"), High Speed Packet Access (HSPA; including High Speed Downlink Packet Access ("HSDPA"), High Speed Uplink Packet Access ("HSUPA"), HSDPA Plus ("HSDPA+"), and HSUPA Plus ("HSUPA+")), Worldwide Interoperability for Microwave Access ("WiMax") (e.g., according to an IEEE 802.16 radio communication standard, e.g., WiMax fixed or WiMax mobile), etc., and other similar radio communication technologies. Cellular Wide Area radio communication technologies also include "small cells" of such technologies, such as microcells, femtocells, and picocells. Cellular Wide Area radio communication technologies may be generally referred to herein as "cellular" communication technologies.

In the context of WLAN, the apparatuses and methods described herein may be for various wireless devices, including access points (APs) and wireless station devices (STAs), each may be equipped with radio frequency (RF) communication capabilities. These devices may incorporate transmission and reception components designed to handle RF signals within specified bandwidths and channels as described herein. The communication components typically include both hardware elements and software implementations for signal processing, enabling modulation and demodulation according to specified communication protocols. These devices may particularly be configured to operate under various wireless communication standards, including those developed by the Institute of Electrical and Electronics Engineers (IEEE) for Wi-Fi applications. The RF components, working in conjunction with antenna systems, enable communication across multiple frequency bands. These frequency bands may include, among others, the 2.4 GHz band supporting protocols such as IEEE 802.11b/g/n/ax, the 5 GHz band supporting IEEE 802.11n/ac/ax/be, and the 6 GHz band supporting newer standards like IEEE 802.11ax/be. Additional operational frequencies may extend to 60 GHz (supporting IEEE 802.11ad/ay) and 800 MHz (supporting IEEE 802.11ah), with antenna systems capable of operating at frequencies such as 28 GHz and 40 GHz. Beyond these specified standards, the devices may support emerging Wi-Fi protocols and alternative wireless communication technologies. These alternatives may include, but are not limited to, Bluetooth technology, dedicated short-range communication systems, Ultra-High Frequency applications (including IEEE 802.11af and IEEE 802.22), and white band frequency utilization. The RF reception chain may typically incorporate essential components such as low noise amplifiers, signal amplification stages, analog-to-digital conversion systems, data buffering mechanisms, and digital baseband processing units, all configured to ensure effective wireless communication capabilities.

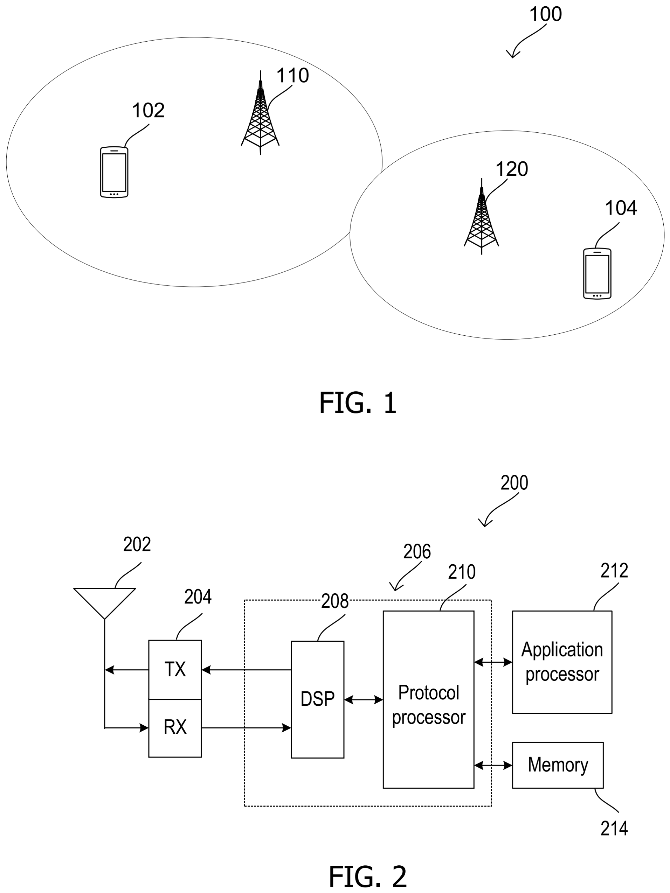

FIGs. 1 and 2 depict a general network and device architecture for wireless communications and/or sensing operations. In particular, FIG. 1 shows exemplary radio communication network 100 according to some aspects, which may include terminal devices 102 and 104 and network access nodes 110 and 120 (e.g. radio access nodes). Radio communication network 100 may communicate with terminal devices 102 and 104 via network access nodes 110 and 120 over a radio access network. Each of terminal devices 102 and 104 or network access nodes 110 and 120 may be a sensing communication device as described herein that may perform a sensing operation. Although certain examples described herein may refer to a particular radio access network context (e.g., 6G, 5G NR, LTE, UMTS, GSM, other 3rd Generation Partnership Project (3GPP) networks, WLAN/WiFi, Bluetooth, mmWave, etc.), these examples are demonstrative and may therefore be readily applied to any other type or configuration of radio access network. The number of network access nodes and terminal devices in radio communication network 100 is exemplary and is scalable to any amount.

In an exemplary cellular context, network access nodes 110 and 120 may be base stations (e.g., eNodeBs, NodeBs, Base Transceiver Stations (BTSs), gNodeBs, or any other type of base station), while terminal devices 102 and 104 may be cellular terminal devices (e.g., Mobile Stations (MSs), User Equipments (UEs), or any type of cellular terminal device). Network access nodes 110 and 120 may therefore interface (e.g., via backhaul interfaces) with a cellular core network such as an Evolved Packet Core (EPC, for LTE), Core Network (CN, for UMTS), or other cellular core networks, which may also be considered part of radio communication network 100. The cellular core network may interface with one or more external data networks. In an exemplary short-range context, network access node 110 and 120 may be access points (APs, e.g., WLAN or WiFi APs), while terminal device 102 and 104 may be short range terminal devices (e.g., stations (STAs)). Network access nodes 110 and 120 may interface (e.g., via an internal or external router) with one or more external data networks. Network access nodes 110 and 120 and terminal devices 102 and 104 may include one or multiple transmission/reception points (TRPs).

Network access nodes 110 and 120 (and, optionally, other network access nodes of radio communication network 100 not explicitly shown in FIG. 1) may accordingly provide a radio access network to terminal devices 102 and 104 (and, optionally, other terminal devices of radio communication network 100 not explicitly shown in FIG. 1). In an exemplary cellular context, the radio access network provided by network access nodes 110 and 120 may enable terminal devices 102 and 104 to wirelessly access the core network via radio communications. The core network may provide switching, routing, and transmission, for traffic data related to terminal devices 102 and 104, and may further provide access to various internal data networks (e.g., control nodes, routing nodes that transfer information between other terminal devices on radio communication network 100, etc.) and external data networks (e.g., data networks providing voice, text, multimedia (audio, video, image), and other Internet and application data). Furthermore, terminal devices 102 and 104 and network access nodes 110 and 120 may perform a sensing operation, particularly radar sensing, in accordance with JCAS architecture. In an exemplary short-range context, the radio access network provided by network access nodes 110 and 120 may provide access to internal data networks (e.g., for transferring data between terminal devices connected to radio communication network 100) and external data networks (e.g., data networks providing voice, text, multimedia (audio, video, image), and other Internet and application data).

In accordance with various aspects described herein, network access nodes 110 and 120 and terminal devices 102 and 104 performing their respective sensing operations in a manner, such that each device may perform its respective sensing operation according to its respective sensing signal configuration. Accordingly, each of these devices may generate and transmit its respective sensing signals according to a respective configuration that may include at least one of frequency resources used to transmit sensing signals, the bandwidth of the sensing signals, transmit power of the sensing signals, and waveform shape of the sensing signals which the respective device may determine before generating and/or transmitting the sensing signals. In some examples, a central orchestrator (e.g. a sensing orchestrator) may determine a respective sensing signal configuration for each device and send information representing the respective sensing signal configuration to the respective device.

The radio access network and core network (if applicable, such as for a cellular context) of radio communication network 100 may be governed by communication protocols that can vary depending on the specifics of radio communication network 100. Such communication protocols may define the scheduling, formatting, and routing of both user and control data traffic through radio communication network 100, which includes the transmission and reception of such data through both the radio access and core network domains of radio communication network 100. Accordingly, terminal devices 102 and 104 and network access nodes 110 and 120 may follow the defined communication protocols to transmit and receive data over the radio access network domain of radio communication network 100, while the core network may follow the defined communication protocols to route data within and outside of the core network. Exemplary communication protocols include 6G, 5G NR, LTE, UMTS, GSM, WiMAX, Bluetooth, WiFi, mmWave, etc., any of which may be applicable to radio communication network 100.

FIG. 2 shows an exemplary internal configuration of a communication device (e.g. a sensing communication device) according to various aspects provided herein. The communication device may include various aspects of radio communication devices (e.g. network access nodes 110, 120) or various aspects of mobile radio communication devices (e.g. terminal device 102, 104) as well. The communication device 200 may include antenna system 202, radio frequency (RF) transceiver 204, baseband modem 206 (including digital signal processor 208 and protocol controller 210), application processor 212, and memory 214. Although not explicitly shown in FIG. 2, in some aspects communication device 200 may include one or more additional hardware and/or software components, such as processors/microprocessors, controllers/microcontrollers, other specialty or generic hardware/processors/circuits, peripheral device(s), memory, power supply, external device interface(s), subscriber identity module(s) (SIMs), user input/output devices (display(s), keypad(s), touchscreen(s), speaker(s), external button(s), camera(s), microphone(s), etc.), or other related components.

Communication device 200 may transmit and receive radio signals on one or more radio access networks. Baseband modem 206 may direct such communication functionality of communication device 200 according to the communication protocols associated with each radio access network, and may execute control over antenna system 202 and RF transceiver 204 to transmit and receive radio signals according to the formatting and scheduling parameters defined by each communication protocol. Although various practical designs may include separate communication components for each supported radio communication technology (e.g., a separate antenna, RF transceiver, digital signal processor, and controller), for purposes of conciseness the configuration of communication device 200 shown in FIG. 2 depicts only a single instance of such components.

Communication device 200 may transmit and receive wireless signals with antenna system 202. Antenna system 202 may be a single antenna or may include one or more antenna arrays that each include multiple antenna elements. For example, antenna system 202 may include an antenna array at the top of communication device 200 and a second antenna array at the bottom of communication device 200. In some aspects, antenna system 202 may additionally include analog antenna combination and/or beamforming circuitry. In the receive (RX) path, RF transceiver 204 may receive analog radio frequency signals from antenna system 202 and perform analog and digital RF front-end processing on the analog radio frequency signals to produce digital baseband samples (e.g., in-phase/quadrature (IQ) samples) to provide to baseband modem 206. RF transceiver 204 may include analog and digital reception components including amplifiers (e.g., low noise amplifiers (LNAs)), filters, RF demodulators (e.g., RF IQ demodulators), and analog-to-digital converters (ADCs), which RF transceiver 204 may utilize to convert the received radio frequency signals to digital baseband samples. In the transmit (TX) path, RF transceiver 204 may receive digital baseband samples from baseband modem 206 and perform analog and digital RF front-end processing on the digital baseband samples to produce analog radio frequency signals to provide to antenna system 202 for wireless transmission. RF transceiver 204 may thus include analog and digital transmission components including amplifiers (e.g., power amplifiers (PAs), filters, RF modulators (e.g., RF IQ modulators), and digital-to-analog converters (DACs), which RF transceiver 204 may utilize to mix the digital baseband samples received from baseband modem 206 and produce the analog radio frequency signals for wireless transmission by antenna system 202. In some aspects, baseband modem 206 may control the radio transmission and reception of RF transceiver 204, including specifying the transmit and receive radio frequencies for operation of RF transceiver 204.

In accordance with various aspects provided herein, the communication device 200 may perform sensing operations within the radio communication network 100. Illustratively, the baseband modem 206, (e.g. the digital signal processor 208) may be configured to perform sensing-related signal processing in addition to traditional communication processing. For example, the baseband modem 206 may be configured to implement techniques like radar waveform generation, matched filtering for target detection, parameter estimation (e.g., range, velocity, angle) of detected targets, and environmental mapping. In some examples, the baseband modem 206 (e.g. the digital signal processor 208) may use its hardware accelerators and parallel processing capabilities to efficiently handle the computationally intensive sensing algorithms alongside communication tasks.

Furthermore, the baseband modem 206 (e.g. the protocol controller 210) may be configured to coordinate and/or manage joint operation of communication and sensing functions. Illustratively, the baseband modem 206 may schedule sensing and communication operations, allocate resources (e.g., time/frequency resources, antenna beams) between the sensing operations and the communication operations, and manage interference between them. The baseband modem (e.g. the protocol controller 210) may further implement sensing control protocols and interfaces to enable coordination with other network entities for distributed sensing operations as described herein.

In some examples, the application processor 212 may be configured to act as a source and sink for sensing data, similar to its role for communication data. The application processor 212 may execute sensing applications that are configured to process and interpret the sensing data received from the baseband modem 206. Illustratively, the application processor 212 may perform at least one of object detection and tracking, environmental mapping, and/or situational awareness services using the sensing data. In some examples, the application processor 212 may interface with external sensors (e.g., cameras, lidars) to fuse data from multiple sensing modalities for enhanced perception capabilities.

Correspondingly, the RF transceiver 204 may further support the transmission and reception of sensing waveforms in addition to communication signals. Illustratively, the RF transceiver 204 may generate and transmit sensing signals (e.g., frequency-modulated continuous waveforms for radar), and may process the received sensing signals to extract target information. In some examples, the RF transceiver 204 can use the same analog and digital components (e.g., amplifiers, filters, modulators/demodulators, ADCs/DACs) for sensing operations and the communication operations, potentially with additional hardware accelerators for sensing-specific tasks. Illustratively, the antenna system 202 may also support both communication and sensing functions, in some examples with separate antenna arrays or shared arrays with beamforming capabilities. In accordance with various aspects, the antenna system 202 can form narrow beams for extended sensing range or wide beams for faster coverage, depending on the sensing requirements and resource constraints. Techniques like MIMO and beamforming can be employed to enhance the sensing performance and enable features like high-resolution target parameter estimation and interference mitigation.

As shown in FIG. 2, baseband modem 206 may include digital signal processor 208, which may perform physical layer (PHY, layer 1) transmission and reception processing to, in the transmit path, prepare outgoing transmit data provided by protocol controller 210 for transmission via RF transceiver 204, and, in the receive path, prepare incoming received data provided by RF transceiver 204 for processing by protocol controller 210. Digital signal processor 208 may be configured to perform one or more of error detection, forward error correction encoding/decoding, channel coding and interleaving, channel modulation/demodulation, physical channel mapping, radio measurement and search, frequency and time synchronization, antenna diversity processing, power control and weighting, rate matching/de-matching, retransmission processing, interference cancelation, and any other physical layer processing functions. Digital signal processor 208 may be structurally realized as hardware components (e.g., as one or more digitally-configured hardware circuits or field programmable gate arrays (FPGAs)), software-defined components (e.g., one or more processors configured to execute program code defining arithmetic, control, and I/O instructions (e.g., software and/or firmware) stored in a non-transitory computer-readable storage medium), or as a combination of hardware and software components. In some aspects, digital signal processor 208 may include one or more processors configured to retrieve and execute program code that defines control and processing logic for physical layer processing operations. In some aspects, digital signal processor 208 may execute processing functions with software via the execution of executable instructions. In some aspects, digital signal processor 208 may include one or more dedicated hardware circuits (e.g., application specific integrated circuits (ASICs), field programmable gate arrays, and other hardware) that are digitally configured to specific execute processing functions, where the one or more processors of digital signal processor 208 may offload certain processing tasks to these dedicated hardware circuits, which are known as hardware accelerators. Exemplary hardware accelerators can include fast Fourier transform (FFT) circuits and encoder/decoder circuits. In some aspects, the processor and hardware accelerator components of digital signal processor 208 may be realized as a coupled integrated circuit.

Communication device 200 may be configured to operate according to one or more radio communication technologies. Digital signal processor 208 may be responsible for lower-layer processing functions (e.g., layer 1/PHY) of the radio communication technologies, while protocol controller 210 may be responsible for upper-layer protocol stack functions (e.g., data link layer/layer 2 and/or network layer/layer 3). Protocol controller 210 may thus be responsible for controlling the radio communication components of communication device 200 (antenna system 202, RF transceiver 204, and digital signal processor 208) in accordance with the communication protocols of each supported radio communication technology, and accordingly may represent the access stratum (AS) and non-access stratum (NAS) (also encompassing layer 2 and layer 3) of each supported radio communication technology. Protocol controller 210 may be structurally embodied as a protocol processor configured to execute protocol stack software (retrieved from a controller memory) and subsequently control the radio communication components of communication device 200 to transmit and receive communication signals in accordance with the corresponding protocol stack control logic defined in the protocol software. Protocol controller 210 may include one or more processors configured to retrieve and execute program code that defines the upper-layer protocol stack logic for one or more radio communication technologies, which can include data link layer/layer 2 and network layer/layer 3 functions. Protocol controller 210 may be configured to perform both user-plane and control-plane functions to facilitate the transfer of application layer data to and from radio communication device 200 according to the specific protocols of the supported radio communication technology. User-plane functions can include header compression and encapsulation, security, error checking and correction, channel multiplexing, scheduling, and priority, while control-plane functions may include setup and maintenance of radio bearers. The program code retrieved and executed by protocol controller 210 may include executable instructions that define the logic of such functions.

Communication device 200 may also include application processor 212 and memory 214. Application processor 212 may be a CPU, and may be configured to handle the layers above the protocol stack, including the transport and application layers. Application processor 212 may be configured to execute various applications and/or programs of communication device 200 at an application layer of communication device 200, such as an operating system (OS), a user interface (UI) for supporting user interaction with communication device 200, and/or various user applications. The application processor may interface with baseband modem 206 and act as a source (in the transmit path) and a sink (in the receive path) for user data, such as voice data, audio/video/image data, messaging data, application data, basic Internet/web access data, etc. In the transmit path, protocol controller 210 may therefore receive and process outgoing data provided by application processor 212 according to the layer-specific functions of the protocol stack, and provide the resulting data to digital signal processor 208. Digital signal processor 208 may then perform physical layer processing on the received data to produce digital baseband samples, which digital signal processor may provide to RF transceiver 204. RF transceiver 204 may then process the digital baseband samples to convert the digital baseband samples to analog RF signals, which RF transceiver 204 may wirelessly transmit via antenna system 202. In the receive path, RF transceiver 204 may receive analog RF signals from antenna system 202 and process the analog RF signals to obtain digital baseband samples. RF transceiver 204 may provide the digital baseband samples to digital signal processor 208, which may perform physical layer processing on the digital baseband samples. Digital signal processor 208 may then provide the resulting data to protocol controller 210, which may process the resulting data according to the layer-specific functions of the protocol stack and provide the resulting incoming data to application processor 212. Application processor 212 may then handle the incoming data at the application layer, which can include execution of one or more application programs with the data and/or presentation of the data to a user via a user interface.

Memory 214 may embody a memory component of communication device 200, such as a hard drive or another such permanent memory device. Although not explicitly depicted in FIG. 2, the various other components of communication device 200 shown in FIG. 2 may additionally each include integrated permanent and non-permanent memory components, such as for storing software program code, buffering data, etc.

In accordance with some radio communication networks, terminal devices 102 and 104 may execute mobility procedures to connect to, disconnect from, and switch between available network access nodes of the radio access network of radio communication network 100. As each network access node of radio communication network 100 may have a specific coverage area, terminal devices 102 and 104 may be configured to select and re-select \ available network access nodes in order to maintain a strong radio access connection with the radio access network of radio communication network 100. For example, terminal device 102 may establish a radio access connection with network access node 110 while terminal device 104 may establish a radio access connection with network access node 112. In the event that the current radio access connection degrades, terminal devices 102 or 104 may seek a new radio access connection with another network access node of radio communication network 100; for example, terminal device 104 may move from the coverage area of network access node 112 into the coverage area of network access node 110. As a result, the radio access connection with network access node 112 may degrade, which terminal device 104 may detect via radio measurements such as signal strength or signal quality measurements of network access node 112. Depending on the mobility procedures defined in the appropriate network protocols for radio communication network 100, terminal device 104 may seek a new radio access connection (which may be, for example, triggered at terminal device 104 or by the radio access network), such as by performing radio measurements on neighboring network access nodes to determine whether any neighboring network access nodes can provide a suitable radio access connection. As terminal device 104 may have moved into the coverage area of network access node 110, terminal device 104 may identify network access node 110 (which may be selected by terminal device 104 or selected by the radio access network) and transfer to a new radio access connection with network access node 110. Such mobility procedures, including radio measurements, cell selection/reselection, and handover are established in the various network protocols and may be employed by terminal devices and the radio access network in order to maintain strong radio access connections between each terminal device and the radio access network across any number of different radio access network scenarios.

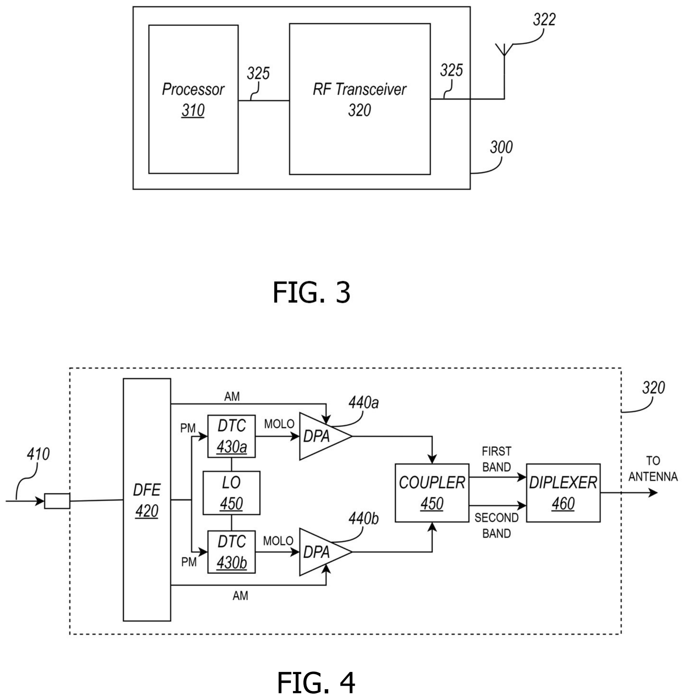

FIG. 3 shows an exemplary illustration of various communication elements of an apparatus for a wireless communication device (e.g. the communication device 200). The apparatus 300 may include processing circuitry 310 (e.g. the baseband modem 206, the application processor 212) that may direct and manage communication operations of the apparatus 300 according to one or more radio communication protocols, and may control transmission/reception of communication signals over at least one or more antenna 322 via an RF transceiver 320. The processing circuitry 310 may include an interface to the RF transceiver 320. The RF transceiver 320 may include at least one RF-chain to process the communication signals associated with the antenna 322 respectively. The apparatus 300 may include the antenna 322, or the apparatus 300 may include an antenna interface couplable to the antenna 322. It is to be noted that the apparatus 300 is depicted as being couplable to the antenna 322, but the apparatus 300 may be couplable to a plurality of antennas, and thereby the RF transceiver 320 may include a plurality of RF-chains, each RF-chain may process communication signals for a respective antenna. The apparatus 300 may transmit and receive radio communication signals with the antenna 322. The apparatus 300 may act as an RF transmitter (e.g. RF transmit circuit) to transmit radio communication signals and it may also act as an RF receiver (e.g. RF receive circuit) to receive radio communication signals.

The processing circuitry 310 may include, or may be implemented, partially or entirely, by circuit and/or logic, e.g., a processor including circuit and/or logic, a memory circuit and/or a logic, which may be configured to manage radio communication operations. The processing circuitry 310 may be configured to communicate with an external main processor (e.g. a host processor, a central processing unit (CPU), a system on chip (SoC)) of the wireless communication device including the apparatus 300 via a designated interface that is coupled to the main processor. In some examples, the processing circuitry 310 may be the main processor of the wireless communication device. The processing circuitry 310 may also access the main memory of the respective wireless communication device via the designated interface. The processing circuitry 310 may further include an interface to the RF transceiver 320.

The processing circuitry 310 may include a digital signal processor (e.g. the digital signal processor 208). The digital signal processor 208 may be configured to perform one or more of error detection, forward error correction encoding/decoding, channel coding, and interleaving, channel modulation/demodulation, physical channel mapping, radio measurement and search, frequency and time synchronization, antenna diversity processing, power control, and weighting, rate matching/de-matching, retransmission processing, interference cancelation, and any other physical layer processing functions.

The processing circuitry 310 may include a modem configured to process baseband signals received from/sent to the antenna 322 via a communication path 325 including a respective RF chain. In various examples, the interface to the RF transceiver 320 of the processing circuitry 310 may be configured to couple the processing circuitry 310 to the communication path 325. Accordingly, the processing circuitry 310 may include Media-Access Control (MAC) circuit and/or logic, Physical Layer (PHY) circuit and/or logic, baseband (BB) circuit and/or logic, a BB processor, a BB memory, Application Processor (AP) circuit and/or logic, an AP processor, an AP memory, and/or any other circuit and/or logic. By way of example, the processing circuitry 310 can perform baseband processing on the digital baseband signals to recover data included in wireless data transmissions.

The processing circuitry 310 may control and/or arbitrate transmit and/or receive functions of the apparatus 300, and perform one or more baseband processing functions (e.g., MAC, encoding/decoding, modulation/demodulation, data symbol mapping, error correction, etc.). The processing circuitry 310 may be configured to provide control functions to the RF transceiver 320 (e.g. to the RF-chain to control and/or arbitrate transmitting and/or receiving radio communication signals). In aspects, functions of processing circuitry 310 can be implemented in software and/or firmware executing on one or more suitable programmable processors, and may be implemented, for example, in a field programmable gate array, application specific integrated circuit, etc. In various examples, the interface to the RF transceiver 320 of the processing circuitry 310 may be configured to couple processing circuitry to the RF transceiver to provide communication in-between.

The RF transceiver 320 may provide RF processing of communication signals conveyed via a communication path within a respective RF chain to transmit radio communication signals via a respective antenna based on signals (e.g. baseband communication signals, digital signals) received from the processing circuitry 310 over the communication path. The RF transceiver 320 may provide RF processing of communication signals conveyed via the communication path 325 to receive radio communication signals via the antenna 322 and provide signals to the processing circuitry 310 over the communication path 325. The processing circuity 310 may be configured to control operations of the RF transceiver 320. The RF transceiver 320 may include a receive path to provide RF processing to receive radio communication signals received from the antenna 322, and a transmit path to provide RF processing to transmit radio communication signals transmitted via the antenna 322.

In a receive (RX) path, The RF transceiver 320 may receive analog radio frequency signals from the antenna 322 via the communication paths 325 and perform analog and digital RF front-end processing on the analog radio frequency signals to produce digital baseband samples (e.g., in-phase/quadrature (IQ) samples) to provide to the processing circuitry 310. In various examples, RF transceiver 320 may include two RF-chains per antenna element, each RF-chain may be designated for a particular polarization. The RF transceiver 320 may include analog and digital reception components including amplifiers (e.g., Low Noise Amplifiers (LNAs)), filters, RF demodulators (e.g., RF IQ demodulators)), and analog-to-digital converters (ADCs), which RF transceiver 320 may utilize to convert the received radio frequency signals to digital baseband samples.

In a transmit (TX) path, the RF transceiver 320 may receive digital baseband samples from processing circuitry 310 and perform analog and digital RF front-end processing on the digital baseband samples to produce analog radio frequency signals to be provided to the antenna 322 via the communication paths 325 for radio transmission. The RF transceiver 320 may thus include analog and digital transmission components including amplifiers (e.g., power amplifiers (PAs), filters, RF modulators (e.g., RF IQ modulators), and digital-to-analog converters (DACs), which the RF transceiver 320 may utilize to mix the digital baseband samples received from processing circuitry 310 and produce respective analog radio frequency signals for radio transmission by the antenna 322. In some aspects, the processing circuitry 310 may control the radio transmission and reception of the RF transceiver 320, including specifying the transmit and receive radio frequencies for the operation of the RF transceiver 320. In some examples, at least one of the amplifiers may include an amplifier circuit provided herein.

FIG. 4 shows an exemplary illustration of a transmit path of an RF transceiver configured for dual-band operation. The RF transceiver 320, of which its transmit path illustrated herein, may be configured for a digital polar transmit for two distinct frequency bands. The RF transceiver 320 may be couplable to processing circuitry (e.g. the processing circuitry 310, a modem) over an interface. The interface may include a communication path designated to carry communication signals 410 between the processing circuitry and an antenna. In some examples, the interface may include a further circuit path to provide communication between the RF transceiver 320 and the processing circuitry for control of the operations. The RF transceiver 320 may further include further components and or circuits, such as further filter circuits, synthesizer circuits, etc. that are not depicted here. The RF transceiver 320 may include various circuits and components deployed on the respective transmission path.

The RF transceiver 320 may include various circuits and components deployed to process and transmit communication signals across two frequency bands. These components may include a digital front end (DFE) 420, digital to time converters (DTCs) 430a and 430b, digital power amplifiers (DPAs) 440a and 440b, a combiner 450 and a diplexer 460.

The digital front end 420 may receive the communication signals 410 via the interface coupling the processing circuitry to the digital front end 420. The digital front end 420 may include a digital front end processing circuitry and further components. The digital front end 420 may be configured to convert the communication signals 410 (e.g. in-phase/quadrature (IQ) signals) into a polar signal including an amplitude modulation (AM) signal (e.g. amplitude control codes) and a phase modulation (PM) signal (e.g. phase control codes). Generated amplitude modulation signals and phase modulation signals may be provided to respective transmit chains for further processing.

In a first transmit chain configured for a first frequency band, the RF transceiver 320 may include a first digital to time converter 430a. The first digital to time converter 430a may be coupled to the digital front end 420. The first digital to time converter 430a may receive the phase modulation signal. The first digital to time converter 430a may be further coupled to a local oscillator (LO) 450. The first digital to time converter 430a may adjust polar modulation parameters based on the phase modulation signal that the digital front end 420 provides to generate a modulated local oscillator signal for the first frequency band. By adjusting the polar modulation parameters based on the phase modulation signal, the first digital to time converter 430a may output a modulated local oscillator (MOLO) signal at the first frequency band. In the first transmit chain, the RF transceiver 320 may further include a first digital power amplifier440a. The first digital power amplifier440a may receive the amplitude modulation signal (e.g. amplitude control codes) setting desired power of the output of the first digital power amplifier440a. The first digital power amplifier440a may further receive the modulated local oscillator signal at the first frequency band and provide an output RF signal at the first frequency band, which is based on the received modulated local oscillator signal and amplitude modulation signal. The first digital power amplifier440a may include a DPC, or an RF-CDAC.

In a second transmit chain configured for a first frequency band, the RF transceiver 320 may include a second digital to time converter 430b. The second digital to time converter 430b may be coupled to the digital front end 420. The second digital to time converter 430b may receive the phase modulation signal. The second digital to time converter 430b may be further coupled to the LO 450. The second digital to time converter 430b may adjust polar modulation parameters based on the phase modulation signal that the digital front end 420 provides to generate a modulated local oscillator signal for the second frequency band. By adjusting the polar modulation parameters based on the phase modulation signal, the second digital to time converter 430a may output a modulated local oscillator (MOLO) signal at the second frequency band. In the second transmit chain, the RF transceiver 320 may further include a second digital power amplifier 440b. The second digital power amplifier440b may receive the amplitude modulation signal (e.g. amplitude control codes) setting desired power of the output of the second digital power amplifier440b. The second digital power amplifier440b may further receive the modulated local oscillator signal at the second frequency band and provide an output RF signal at the second frequency band, which is based on the received modulated local oscillator signal and amplitude modulation signal. The second digital power amplifier440b may include a DPC, or an RF-CDAC. Although only two transmit chains have been illustrated in the figure, the RF transceiver may include multiple transmit chains, namely more than two transmit chains, such as 3, 4, 5, ..., N, N being an integer.

The RF transceiver 320 may further include the combiner 450. The combiner 450 may include a dual-band transformer. The combiner 450 may be configured to process RF signals from the first transmit chain and the second transmit chain. Specifically, the combiner 450 may couple the RF signals output by the digital power amplifiers 440a and 440b received by the first end (e.g. input) of the combiner 450 to the second end (e.g. output) of the combiner 450 to further components of the RF transceiver 320, which are coupled to the second end of the combiner while maintaining their respective frequency characteristics. The combiner 450 (e.g. the dual band transformer) may facilitate proper impedance matching for both frequency bands to optimize power transfer and minimize signal reflection.

In other words, the dual band transformer may facilitate impedance matching across both frequency bands to ensure that output impedances of each of first and second transmit chain are matched to subsequent components. The dual band transformer may couple RF signals from both digital power amplifiers 440a and 440b into two distinct outputs corresponding to their respective frequency bands. For example, the signal from digital power amplifier440a is routed to the first band output and the signal from digital power amplifier440b is routed to the second band output. The dual-band transformer may operate across the first and second frequency bands by employing impedance transformation techniques tailored for each band.

The RF transceiver 320 may further include the diplexer 460 coupled to the outputs of the combiner 450. The diplexer 460 may combine RF signals from the first band output and second band output of the combiner into a single RF signal for transmission via an antenna. The diplexer 460 may combine the RF signals from the first band output and second band output of the combiner into a single RF signal. In this constellation, the diplexer 460 may include a first terminal at a first end that may receive the first band output, a second terminal at the first end that may receive the second band output, and a terminal at a second end that provides the combined signal. This combined signal is routed to an antenna for transmission. While combining signals, the diplexer 460 may also provide isolation between paths corresponding to different frequency bands to prevent interference or leakage between signals of different bands during transmission.

It is to be noted that while the diplexer 460 is depicted for transmission in this architecture, a diplexer can also support reception by routing incoming RF signals from antennas back to appropriate receive chains based on their frequencies. In a receive RX path of an RF transceiver (e.g. the RF transceiver 320), a diplexer may separate incoming signals based on their frequency bands and route them to appropriate RF chains for further processing. In the above-illustrated diplexer, this time, the diplexer may receive those incoming signals at the terminal at the second end and separate the received incoming signals into two separate signals at two separate frequency bands. In this illustrative example, the diplexer may provide a first signal at the first frequency band from the first terminal at the first end and a second signal at the second frequency from the second terminal at the second end. The diplexer may be a three-port passive RF device that uses filters (e.g., high-pass, lowpass, or band-pass filters) to divide signals into distinct frequency bands. This functionality may enable the RF transceiver to handle multiple frequency bands simultaneously using a shared antenna.

In accordance with various aspects described herein, an apparatus (e.g. diplexer circuit) may be employed as the diplexer 460 configured for operations described for the diplexer 460. The diplexer circuit may separate input signals received at a common input terminal into two distinct output signals based on their frequencies. The diplexer circuit may include a combination of components, including a common input terminal, two inductors coupled to the common input terminal in an electromagnetic coupling configuration, and two separate output terminals: one for lower-frequency signals and the other for higher-frequency signals.

The diplexer circuit may include a first inductor and a second inductor, both coupled to the common input terminal. These inductors may be configured to handle signals at two different frequency bands, illustratively one band being a lower band and the other being a higher band. The diplexer circuit may implement a frequency-domain multiplexing allowing two signals in different frequency bands to share a common transmission path, such as an antenna or coaxial cable. The diplexer circuit may include the first and second inductor in an electromagnetic coupling configuration.

Illustratively, the first and second inductors are disposed in a designated spatial proximity, such that they electromagnetically couple to each other when the diplexer circuit is operational to separate or combine signals based on their frequency. The electromagnetic coupling configuration between the first and second inductors. This coupling may provide an efficient signal routing while minimizing unwanted interference or degradation of performance.

The diplexer circuit may include two terminals through which the two signals at different frequency bands may be received by the diplexer circuit or may be output by the diplexer circuit. Aspects with respect to the diplexer circuit are described herein mostly with an operation in a configuration in which the diplexer circuit might be in an RX chain of an RF transceiver (e.g. the RF transceiver 320) to receive a signal (e.g. a communication signal) at two different frequency bands and separate this signal into a first signal at a first frequency band (e.g. a lower frequency band) and a second signal at a second frequency band (e.g. a higher frequency band), yet this should not be considered as limiting. Some of these aspects are provided to illustrate some of the functional behavior of the diplexer circuit and the skilled person would recognize their corresponding functions when the diplexer circuit is used in a transmit chain of the RF transceiver.

The lower-frequency band output terminal may connect to the first inductor, while the higher-frequency band output terminal may connect to the second inductor. In such a configuration, the first and second inductors may separate signals received from a common terminal into signals of two different bands due to the distinct impedance and resonant properties of the inductors, which may be designed to respond selectively to signals within specific frequency ranges. In this constellation, the diplexer circuit may include a common input terminal to receive signals at two different paths from a common signal path, illustratively from an RX path connected to an antenna in the RF transceiver.

The first inductor and the second inductor may form the core components of the diplexer circuit. As indicated previously, these inductors may be configured to operate in an electromagnetic coupling configuration, illustratively by positioning them relative to each other (e.g. on a substrate) to facilitate magnetic fields generated by one inductor to influence the other. The coupling may be achieved with a spatially arranged inductors such that their magnetic fields overlap to at least a desired extent. This arrangement may enable the diplexer circuit to use this desired magnetic coupling as a design parameter to optimize performance, including signal isolation and rejection.

Illustratively, the first inductor may be disposed as an outer loop, while the second inductor may be positioned concentrically within the first inductor. Such a layout may minimize the physical footprint while maintaining the required coupling coefficient. The specific degree of coupling can be adjusted by selecting appropriate physical spacing or geometric alignment of the inductors.

The output terminals, namely the lower-frequency band output terminal and the higher frequency band output terminal may correspond to the separated frequency bands. The lower-frequency band output terminal may connect to the first inductor and direct signals within a lower frequency range to a designated low band output. Similarly, the higher-frequency band output terminal may connect to the second inductor and direct signals within a higher-frequency range to a designated high band output.

The first inductor and the second inductor may accordingly separate signals received from the common input terminal into the lower frequency band output terminal and the higher frequency band output terminal based on the frequencies of the received signals. The inductors may have designated inductance values to facilitate the separation through resonation, i.e. by resonating within their respective frequency bands. These inductance values may be selected based on the desired operational frequency ranges and the overall impedance requirements of the diplexer circuit.

In an example, the first and second inductors may be implemented on the same substrate or chip layer using modem fabrication techniques. For example, the first and second inductors may be etched onto the topmost metal layers of the chip for their substantial physical dimensions to ensure detectability and ease of fabrication. In some examples, the first and second conductors are the first components following the common input terminal within the diplexer circuit, which may facilitate s significant reduction of the required physical area compared to designs using separate filters or additional spacing.

The interaction between the first and second inductors and the output terminals may include the frequency-selective behavior of the inductors. Each inductor may provide a low impedance path for signals within its designated frequency band while offering high impedance to signals outside this range. This frequency-dependent behavior may allow that signals entering the common input terminal are effectively split and routed to the appropriate output terminal. The magnetic coupling configuration may further enhance this process by improving signal isolation and reducing interference between the two paths. For example, the first inductor, connected to the lower-frequency band output terminal, may exhibit a high-quality factor (Q) to minimize insertion loss for lower-frequency signals. The second inductor, connected to the higher-frequency band output terminal, may also exhibit a high quality factor, but to minimize insertion loss for higher-frequency signals.

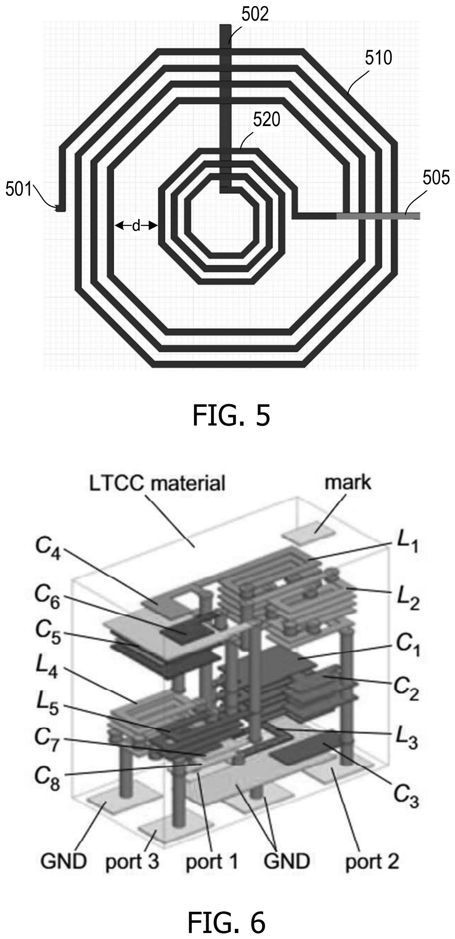

FIG. 5 shows an illustrative example of the diplexer circuit in accordance with various aspects described herein. The diplexer circuit may leverage the electromagnetic coupling between inductors to separate signals into distinct frequency bands. As depicted herein, the diplexer circuit may include the common input terminal 505 coupled to the first inductor 510 and the second inductor 520 included by the diplexer circuit. The first inductor 510 and the second inductor 520 may be arranged in an electromagnetic coupling configuration and configured to separate incoming signals based on their frequency. The first inductor 510 and the second inductor 520 may direct signals received at the common input terminal 505, which are of the lower frequency band, to the lower frequency band output terminal 501 and signals received at the common input terminal 505, which are in the higher frequency band, to the higher frequency band output terminal 502.

To direct a received signal of a first frequency band (e.g. lower frequency band) to the lower frequency band output terminal and a received signal of a second frequency band (e.g. higher frequency band) to the higher frequency band output terminal, the first inductor 510 and the second inductor 520 may be configured to route signals of distinct frequency bands to their respective output terminals. Signals of a first, lower frequency band may be routed to the lower frequency band output terminal 501, while signals of a second, higher frequency band may be routed to the higher frequency band output terminal 502. The first inductor 510 and the second inductor may have a particular resonant characteristics of the inductors, which are tuned to specific frequency ranges, to facilitate to such a routing. Correspondingly, the diplexer circuit may separate signal efficiently, and in some cases without interference between the bands. The electromagnetic coupling configuration between the first inductor 510 and the second inductor 520 may enhance the interaction between the inductors and may reduce the need for additional components.

In some examples, the first inductor 510 and the second inductor 520 may be disposed (i.e. provided) in a concentric arrangement. The first inductor 510 may be positioned concentrically around the second inductor 520. Such a spatial configuration may allow the inductors to interact electromagnetically while minimizing the overall footprint of the diplexer circuit. In an example, as illustrated in FIG. 5, the second inductor 520 may form a second loop (e.g. an inner loop), while the first inductor 510 forms a first loop (e.g. an outer loop). The first loop and the second loop may be positioned on the same plane, with an input connection element (i.e. input connector) extending between the first loop and the second loop may, which may connect at least one of the first loop or the second loop to the common input terminal 505.

In some examples, the first loop and the second loop may be non-overlapping loops. In an example that the first loop is an outer loop and the second loop is an inner loop, the outer loop formed by the first inductor 510 may enclose the inner loop formed by the second inductor 520. In this constellation, the inner loop may be disposed within an area on the plane, in which the area may be enclosed by the outer loop, which may maintain the necessary electromagnetic coupling for effective signal separation.

In an example, the inner loop and the outer loop may be separate by a spacing that has been selected to achieve a desired magnetic coupling coefficient between the first inductor 510 and the second inductor. The predetermined spacing between the inner loop 520 and the outer loop 510, denoted as distance d, may achieve the desired magnetic coupling coefficient. In some examples, this spacing may be selected to achieve a coupling coefficient that can satisfy the isolation and rejection specifications of the diplexer circuit. It is to be recognized that adjusting this distance may allow designers to fine-tune the electromagnetic interaction between the inductors with respect to designated performance objectives. For example, the may balance the trade-offs between coupling strength, insertion loss, and signal isolation, to enable the diplexer circuit to achieve optimal operation.

In an example, the diplexer circuit may be disposed on multiple layers of a multi-layer circuit. For example, the first inductor 510, the second inductor 520, and their connections may be implemented on a single substrate. For example, the first inductor 510 and the second inductor 520 may reside on a first layer of the substrate, with the output connection elements (i.e. output connectors) for the lower frequency band output terminal 501 and the higher frequency band output terminal 502 extending to a second layer. The lower frequency band output terminal 501 and the higher frequency band output terminal 502 may be disposed on the first layer. The common input terminal 505 may connect to the first inductor 510 and the second inductor 520 via a common input connection element (i.e. common input connector) positioned on the second layer as well. Such features may provide an additional design flexibility for the integration of the diplexer circuit with other components in the RF front end.

In an alternative implementation, the diplexer circuit may include a first layer and a second layer, with the inductors distributed between these layers. For instance, the first inductor 510 may reside on the first layer, while the second inductor 520 may be implemented on the second layer. This vertical separation can provide the desired coupling coefficient, particularly in designs where multi-layer substrates are available. The vertical arrangement can reduce the required horizontal area of the circuit.

The electromagnetic coupling configuration between the first inductor 510 and the second inductor 520 may be provided to achieve a predetermined electromagnetic coupling between them to achieve a coupling coefficient that satisfies the isolation and rejection requirements of the diplexer circuit. For example, by adjusting parameters such as the spacing d and the geometric alignment of the inductors, and also the inductance of these inductor, the diplexer circuit can achieve the desired electromagnetic interaction. This approach can be used to consider the magnetic coupling as a design parameter.

In an example, the diplexer circuit may be integrated with additional components, such as a switch or a combiner, on a single chip, which can enhances the functionality and usability of the diplexer circuit in RF front-end designs for wireless communication systems. The compact and efficient design of the coupled inductors can support such integration, enabling the diplexer to coexist with other components without compromising performance.

The diplexer circuit described herein exemplifies a design that can successfully leverage the concentric arrangement, adjustable coupling coefficient, and planar configuration of the inductors, with which the circuit can achieve precise signal separation, compactness, and high performance. These characteristics can make the diplexer suitable for use in modem RF communication systems to address the challenges of miniaturization, performance, and cost.

A typical diplexer may generally have two filtering paths, one for high-frequency signals and the other for low-frequency signals, used to separate or combine signals during transmission and reception. Each of these filters may usually be designed using a combination of inductor and capacitor components. To achieve low signal loss, the quality of these inductors is crucial. Larger inductors tend to have higher quality, but they are also more prone to interference from nearby inductors. In order to enhance the isolation between signal paths, it may be necessary to employ a specific spatial separation for the inductors to mitigate undesired electromagnetic coupling as described in accordance with FIG .5, in which this prescribed distance can be realized through two primary modalities: vertical spacing within the multilayer stack up, or horizontal spacing when the inductors are positioned within the same layer or closed layers. It may be noteworthy that vertical spacing can be a viable option in non-semiconductor technologies characterized by multiple, thick-layer metal.

FIG. 6 shows an illustrative example of a miniaturized diplexer implemented using low-temperature co-fired ceramic (LTCC) technology, which can provides a multi-layer approach to achieve low insertion loss for LTE applications. The LTCC substrate material facilitates the stacking of multiple layers of inductors and capacitors, enabling a compact layout with enhanced isolation and optimized performance metrics. The arrangement can leverage vertical spacing between layers to mitigate undesired electromagnetic coupling and maintain high signal integrity; however, this approach may not be tenable for on-chip configurations, wherein key active elements such as switches, detectors, and other components are designed within a single chip alongside a diplexer.

In the design, inductors such as L1, L2, and L3 are distributed across different layers of the LTCC stack. These inductors may correspond to components in distinct frequency paths of the diplexer, with L1 and L2 potentially forming part of the coupled inductors used for signal separation between lower and higher frequency bands. Capacitors C1 through C8 are positioned to complement the inductive elements, enabling precise tuning of the resonant frequencies for the two signal paths. The interaction between these capacitors and inductors can define the frequency-selective characteristics of the diplexer.

The use of LTCC technology can allow vertical separation between layers, as evident from the layout where components are stacked rather than spread laterally. Ports 1, 2, and 3 may correspond to connection terminals for signal input and output. Port 1 may represent the common input terminal, while ports 2 and 3 may correspond to the output terminals for the lower and higher frequency bands, respectively. This vertical separation can address the challenges of electromagnetic coupling between signal paths. By using thick metal layers within the LTCC stack, the design can achieve controlled isolation and optimized coupling coefficients. The coupling can be fine-tuned to meet the isolation and rejection specifications of the diplexer circuit, contributing to its low insertion loss and high performance. The integration of multiple layers further reduces the overall area of the diplexer while maintaining high-quality signal handling.

In an example, the LTCC implementation may align with the aspects described herein to leverage coupled inductors as a design parameter. Here, the use of multi-layer structures can provide an alternative to on-chip configurations, particularly for applications where miniaturization and cost-efficiency are critical. Generally, coupling between the inductors of the two different frequency band of the diplexers is not desirable and reduces the isolation between the two paths. The aspects provided herein, on the other hand, use this coupling and take advantage of its existence, as a design parameter, which may not only reduce the physical space needed because one inductor is embedded within another but can also enhance the overall performance, as measured by KPIs.

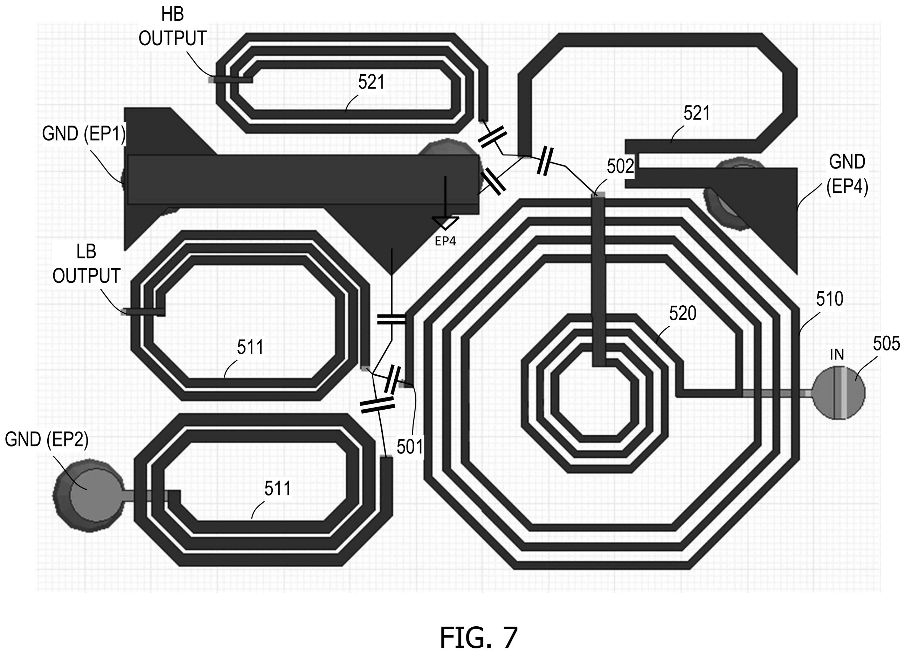

FIG. 7 shows an exemplary illustration of a diplexer including the diplexer circuit. The diplexer circuit, as described, may separate signals across two distinct frequency bands. The common input terminal 505 may facilitate the entry of RF signals into the diplexer at an RX path. From this point, the first inductor 510 and the second inductor 520, configured in an electromagnetic coupling arrangement, may separate the RF signals. They direct the lower frequency signals to the lower frequency band output terminal 501, while directing higher frequency signals to the higher frequency band output terminal 502.

The diplexer may further include additional components that facilitate frequency band filtering and integration with external circuits. The first capacitive element (e.g. capacitor), connected to the first inductor 510 may interact with the first further diplexer components 511. Similarly, the second capacitive element (e.g. capacitor) may connect the second inductor 520 to the second further diplexer components 521. In an example, the capacitive elements may have designated capacitance values that complement the inductance of the first and second inductors. For instance, the first capacitive element and the first inductor 510 may together define a resonant circuit tuned to the lower frequency band to facilitate that signals within this band experience minimal impedance and are directed efficiently to the lower frequency band output terminal 501. The same principle may apply to the second capacitive element and the second inductor 520, which may form a resonant circuit for the higher frequency band to facilitate signals within this band are routed to the higher frequency band output terminal 502. The first further diplexer components 511 and second further diplexer components 521 may include additional capacitors, resistors, or active elements to refine the filtering characteristics and ensure compatibility with downstream circuits.

The interaction between the inductors and capacitive elements may enhance the effectiveness of the frequency separation. For example, the first capacitive element may not only aid in filtering but may also provide a maintenance of the desired impedance matching between the input and output terminals. This impedance matching may minimize reflections and optimize signal transfer, contributing to the overall key performance indicators of the diplexer.

The diplexer circuit may also incorporate ground terminals to stabilize the circuit and improve isolation. A first ground terminal may couples to the first inductor 510 through a first ground connection, while a second ground terminal may couple to the second inductor 520 through a second ground connection. These connections may provide a stable reference point for the inductors, reducing noise and ensuring proper operation of the resonant circuits. Illustratively, the ground connections may have low impedance to effectively shunt unwanted noise and maintain the integrity of the signals processed by the diplexer. For instance, the first ground terminal may be connected to the substrate ground plane via a via or trace, ensuring that the first inductor 510 has a stable reference point. Similarly, the second ground terminal may stabilize the operation of the second inductor 520.

The ground connections may also interact with the capacitive elements to enhance the diplexer's isolation. By providing a low-impedance return path for the capacitive currents, these ground connections may help to maintain the desired coupling coefficient between the inductors while preventing unwanted interference between the signal paths. For example, the first ground terminal may work in conjunction with the first capacitive element to isolate the lower frequency signal path from the higher frequency signal path.

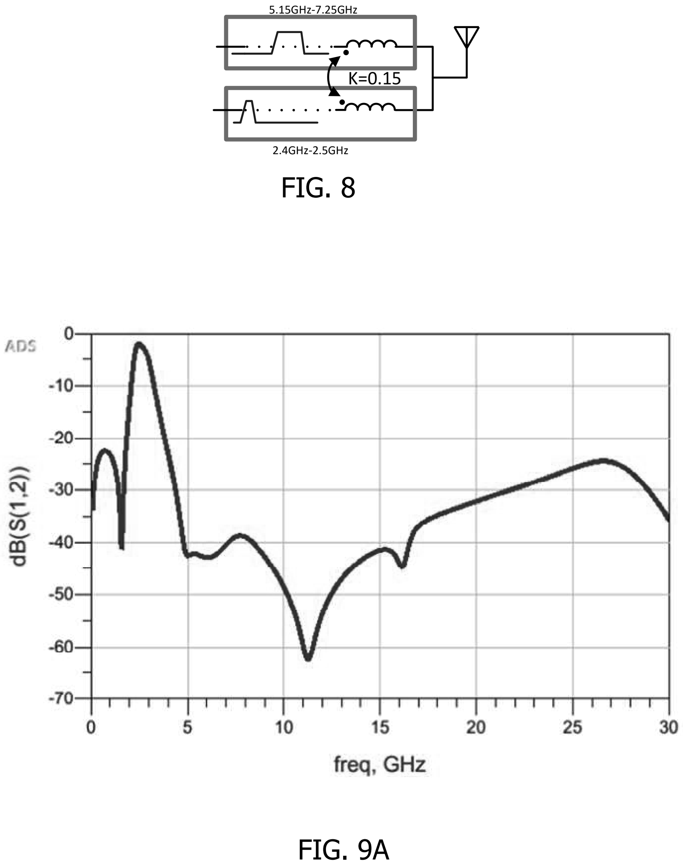

FIG. 8 shows a schematic example of a diplexer circuit designed for operation across two distinct frequency bands, illustratively the diplexer circuit describe in accordance with FIG. 5. The first inductor 510 and the second inductor are arranged to achieve an electromagnetic coupling coefficient of 0.15, for the signal separation. The signals are divided into two paths: the lower frequency band, spanning 2.4 GHz to 2.5 GHz, and the higher frequency band, spanning 5.15 GHz to 7.25 GHz. The lower frequency band signal is directed to the lower frequency band output terminal 501, while the higher frequency band signal is routed to the higher frequency band output terminal 502.

This diplexer employs coupled inductors specifically designed to operate across two isolated frequency bands as described herein. The coupling coefficient of 0.15 is intentionally utilized to optimize the performance of the diplexer. This coupling reduces the required inductance values of the inductors compared to designs without coupling. For example, the selected inductance values are 9.5 nH for the lower frequency band and 2.5 nH for the higher frequency band. Without leveraging coupling, the required inductance values would increase to 10.5 nH and 3.6 nH, respectively. This adjustment would result in a 10% increase in the size of the low band inductor and a 27% increase in the size of the high band inductor. Consequently, no-coupling version necessitates separation of the inductors in the layout which further expanding the overall layout dimensions. Given the isolation and rejection specifications, we are limited to the coupling factor of 0.15. However, more relaxed specifications can result in higher coupling which can save even more area in the layout.

By selecting a coupling coefficient of 0.15, the design achieves the desired balance between isolation and interaction, ensuring that the signals in one path do not interfere with the other. This coupling also facilitates a compact layout, as the physical separation between the inductors, denoted as distance d, is carefully adjusted to achieve the intended coupling coefficient. The inclusion of this coupled inductor configuration in the diplexer aligns with the use of coupling being emphasized as a design parameter. Illustratively, this diplexer employs coupling to handle distinct frequency bands, opening new design possibilities and providing significant advantages in compactness and performance optimization.

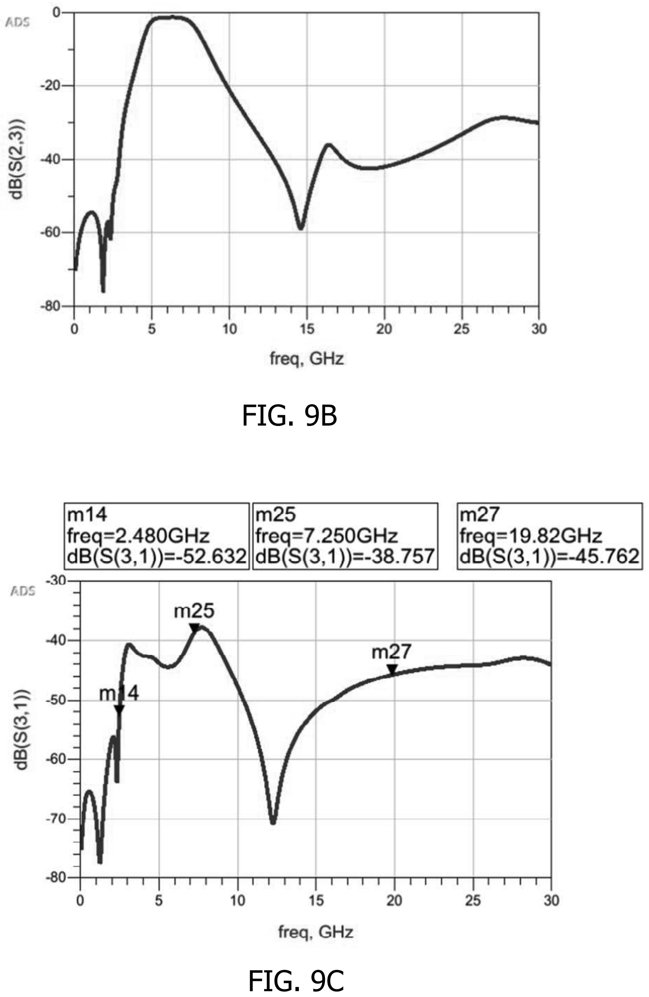

FIGs. 9A-9C illustrate an example of the performance characteristics of the diplexer circuit designed with coupled inductors 510 and 520, as described in FIG. 8. FIG. 9A represents the response of the diplexer circuit, showing the transmission of signals from the common input terminal 505 to the lower frequency band output terminal 501, depicted as S(1,2). The response demonstrates that the low-band path effectively transmits signals within the 2.4 GHz to 2.5 GHz range while suppressing signals outside this range. FIG. 9B represents S(2,3), which shows the transmission of signals from the common input terminal 505 to the higher frequency band output terminal 502. This response indicates that the high-band path, defined by the second inductor 520 and its associated components, efficiently transmits signals within the 5.15 GHz to 7.25 GHz range while rejecting signals outside this band. FIG. 9C represents S(3,1), showing the isolation between the low-band and high-band signal paths. The achieved isolation, exceeding 38 dB, confirms the effectiveness of the coupling coefficient K=0.15 in maintaining signal separation between the two paths. This isolation ensures that signals in one frequency band do not interfere with signals in the other, aligning with the isolation and rejection specifications as described. The intentional use of coupling as a design parameter contributes to both compactness and performance optimization.

In accordance with various aspects described herein, an apparatus (e.g. transmission circuit) may be employed as the combiner 450 configured for operations described for the diplexer 460. In a transmit path, the transmission circuit may provide a coupling of signal paths including low frequency band signal paths and high frequency band signal paths at one end of the transmission circuit to other end of the transmission circuit to achieve efficient and interference-free operation in dual-band systems. The transmission circuit may include two transformer circuits: a first transformer circuit (which may also be referred to as first transformer herein) configured to handle signals within a first frequency band and a second transformer circuit (which may also be referred to as second transformer) configured to handle signals in a second frequency band. In an example, the magnetic fields of these transformers may interact with each other. For example, the second transformer may be arranged to generate a magnetic field that opposes the magnetic field of the first transformer as described herein. This may include that the second transformer may be disposed in relation to the first transformer circuit to generate that opposing magnetic field. This configuration may cancel the magnetic coupling between the two transformers for simultaneous dual-band operation without compromising performance or spectral cleanliness. Illustratively, output current in the second transformer, generated by magnetic field from first transformer may be cancelled due to antisymmetric configuration of second transformer relative to first transformer.

In dual-band systems, as also described herein, diplexers may often serve to separate or combine signals across two distinct frequency bands. In a transmit path, the operation of the diplexer is to combine signals, which may be coupled by the transmission circuit described herein. In an example, the first transformer of the transmission circuit may be dedicated to signals within a lower frequency band (for example, LB), while the second transformer may operate in a higher frequency band (HB). The first transformer and the second transformer may operate concurrently to enable efficient signal transmission within both bands.

The first transformer may magnetically couple signals within the first frequency band and generates a magnetic field with a first orientation. This magnetic field may be clockwise or counterclockwise, depending on the specific winding structure. The first transformer may include windings arranged on a plane, which may be implemented using planar magnetic structures. Such planar configurations can optimize area utilization while providing a coupling mechanism. In practice, the first transformer may be configured to enclose other components of the transmission circuit, including the second transformer, to ensure efficient use of silicon area while also facilitating the cancellation of the magnetic fields as described herein. For example, in integrated circuit implementations, the layout of the IC may position the windings of the first transformer in such a way that they provide sufficient space for the second transformer while maintaining the desired magnetic orientation.

The second transformer may operate within the second frequency band and generate a magnetic field with an orientation (i.e. second orientation) opposite to the first transformer's magnetic field, at least in specific regions. This opposition may occur through an anti-symmetric arrangement of its windings. For example, the second transformer may include windings that generate clockwise magnetic fields in one portion and counterclockwise magnetic fields in another, which may facilitate the canceling of the magnetic coupling from the first band (e.g. LB) to the second band (e.g. HB), and vice versa. In an example, the second transformer may also have a winding configurations to facilitate such a generation of the second magnetic field, such as 8-shaped, S-shaped, or Z-shaped windings.

With respect to the anti-symmetric arrangement of windings of the second transformer, the first transformer may include windings that are arranged such that the magnetic fields on both the primary and secondary winding of the transformer are oriented clockwise. In contrast, the second transformer may have windings that produce clockwise fields on its upper portion and counterclockwise fields on its lower portion. To implement this feature, the winding structures may employ precise geometries and placements, as described herein. For instance, the windings of the second transformer may be mirrored relative to a central axis within the plane of the first transformer. Such a symmetry may simplify the cancellation of magnetic fields, reducing the risk of residual coupling.

The interaction between the first and second transformers is fundamental to the circuit's operation. The spatial arrangement of the transformers, combined with their respective winding orientations, ensures that the fields generated by one transformer do not interfere with the signals managed by the other. The configuration may be optimized by positioning the second transformer within the first transformer's structure, utilizing the area inside the windings of the first transformer. This layout not only reduces the overall silicon area required but also enhances the magnetic field cancellation by aligning the opposing fields more effectively.

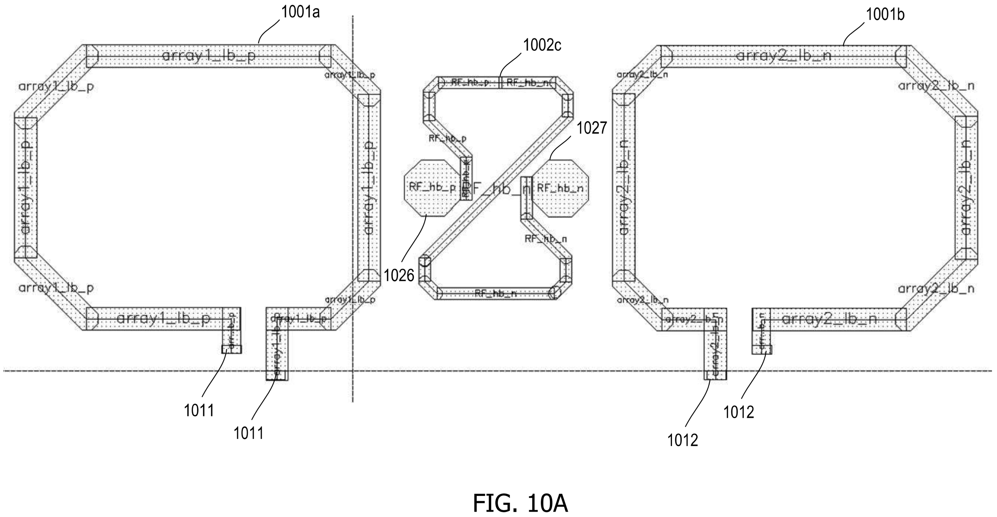

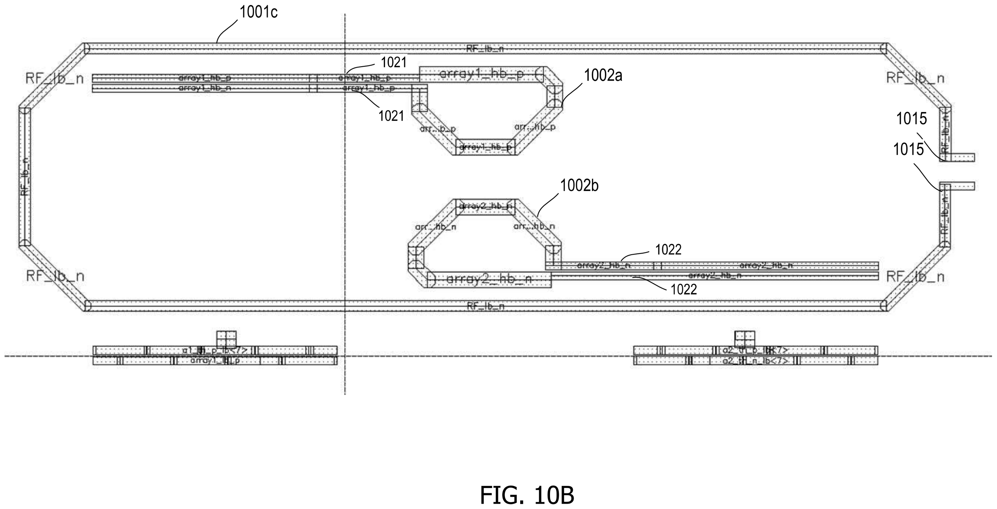

FIGs. 10A and 10B illustrate a schematic example of the transmission circuit as described herein. In these illustrations, FIG 10A illustrates a first layer (e.g. upper layer) of the transmission circuit while FIG. 10B illustrates a second layer (e.g. lower layer) of the transmission circuit, each illustrating a specific set of components that together form the functional elements of the circuit, illustratively including the first transformer and the second transformer described herein. The transmission circuit depicted implement a dual-frequency transmission system (e.g. a dual-band transformer) configured to operate concurrently in low and high frequency bands.

In these illustrations, the first transformer includes windings 1001a, 1001b, and 1001c. The second transformer includes windings 1002a, 1002b, and 1002c. Illustratively, the first transformer may include a first primary winding 1001a, a second primary winding 1001b, and a secondary winding 1001c. The first primary winding 1001a and the second primary winding 1001b may magnetically couple signals flowing within to the secondary winding 1001c. The second transformer may also include a first primary winding 1002a, a second primary winding 1002b, and a secondary winding 1002c. The first primary winding 1002a and the second primary winding 1002b may magnetically couple signals flowing within to the secondary winding 1002c. The first layer of the transmission circuit may include the first primary winding 1001a and the second primary winding 1001b of the first transformer and the secondary winding 1002c of the second transformer. The second layer complements the first layer with the secondary winding 1001c of the first transformer and the first primary winding 1002a and the second primary winding 1002b of the first transformer.

The first primary winding 1001a of the first transformer may be associated with the low band signal of a first (e.g. positive) polarity. The first primary winding 1001a may form a loop structure and may be configured to generate a magnetic field with a specific orientation to couple low band signals effectively. The first primary winding 1001a may include terminals 1011 that may be configured to connect with external circuitry in the transmit chain, illustratively to first RF circuits configured to output low band RF signal to the terminals 1011, to facilitate the transmission of low band signals.

The second primary winding 1001b of the first transformer may be associated with low band signal and of a second (e.g. negative) polarity. In an example, the second primary winding 1001b of the first transformer may be disposed in a configuration that mirrors that of the first primary winding 1001a of the first transformer1001a, forming a complementary loop structure. The second primary winding 1001b may include terminals 1012 that may provide an interface for external connection in the transmit chain, illustratively to connect the second primary winding 100b to second RF circuits configured to output a further low band RF signal to the terminals 1012. Together, the first primary winding 1001a and the second primary winding 1001b of the first transformer may contribute to the generation of a first magnetic field in the first transformer. In an example, the low band RF signal and the further low band RF signal may be signals at different transmit chains. In an example, they may be differential signals.

The first primary winding 1002a of the second transformer may be associated with high band signal of a first (e.g. positive) polarity. In an example, the first primary winding 1002a of the second transformer may overlap with the upper section (first winding structure) of the secondary winding 1002c of the second transformer, creating a coupled pair for transmitting high band signals. The first primary winding 1002a may include terminals 1021 that may be configured to connect to external circuitry in the transmit chain, illustratively to first RF circuits configured to output high band RF signal to the terminals 1021, to facilitate transmission of high band signals.

The second primary winding 1002b of the second transformer may be associated with high band signals of a second (e.g. negative) polarity. In an example, the second primary winding 1002b of the second transformer may overlap with the lower section (second winding structure) of the secondary winding 1002c, to form a complementary coupling pair for high band signals. The second primary winding 1002b may include terminals 1022 that may be configured to couple to external circuitry in the transmit chain, illustratively to second RF circuits to output a further high band RF signal to the terminals 1022. In an example, the high band RF signal and the further high band RF signal may be signals at different transmit chains. In an example, they may be differential signals.

The secondary winding 1002c of the second transformer may include the upper section, which may be referred to as first winding structure, and the lower section, which may be referred to as second winding structure coupled to each other. In other words, the first winding structure and the second winding structure of the secondary winding 1002c may form the secondary winding. The first winding structure may include a terminal 1026 configured to couple a further component (e.g. diplexer) of the transmit path towards the antenna to provide the RF high band signal to the further component. The second winding structure may include a terminal 1027 configured to couple a further component of the transmit path towards the antenna to provide the further RF high band signal. The secondary winding 1002c of the second transformer may at least partially overlap the first primary winding 1002a and the second primary winding 1002b of the second transformer to magnetically couple the RF high band signals (i.e. the RF high band signal and the further RF high band signal) from the terminals 1021 and 1022 to the terminals 1026 and 1027 respectively.

The secondary winding 1002c of the second transformer may be provided in an anti-symmetric configuration with the first and second primary windings 1002a, 1002b of the second transformer. The anti-symmetric configuration of 1002c may allow the second transformer to generate opposing magnetic fields in its upper and lower sections, to cancel out the magnetic coupling with the first transformer. Terminals 1026 and 1027 may serve as connection points for high band signals to external circuitry.

The secondary winding 1001c of the first transformer may at least partially overlap the first primary winding 1001a and the second primary winding 1001b of the first transformer from the first layer to facilitate the magnetic coupling for low band signals (i.e. the low band signal and the further low band signal) from the terminals 1011 and 1012 to terminals 1015 included by the secondary winding 1001c to further components (e.g. diplexer) in the transmit chain towards the antenna.

The first transformer, including the windings 1001a, 1001b, and 1001c, may handle signals within the LB. These windings may be arranged to generate magnetic fields with the same orientation. Illustratively, the first and second primary winding 1001a, 1001b and the secondary winding 1001c of the are arranged to generate respective magnetic fields oriented in the same orientation that is opposite to the second orientation that the second transformer generates. For example, the loops formed by the first primary winding 1001a and the second primary winding 1001b may both generate clockwise magnetic fields.

The second transformer, including the windings 1002a, 1002b, and 1002c may operate in the HB. The anti-symmetric configuration of the secondary winding 1002c of the second transformer may facilitate that the magnetic fields that the second transformer generates oppose those of the first transformer. For example, the upper section of the secondary winding 1002c may generate a clockwise magnetic field while the lower section generates a counterclockwise magnetic field to cancel the coupling effect of the first magnetic field that the first transformer generates.

In an example, in which the first primary winding 1001a and the second primary winding 1001b of the first transformer being arranged on a plane with a spaced apart relationship, the second transformer may be disposed between the first primary winding 1001a and the second primary winding 1001b within that space. The position of the secondary winding 1002c of the second transformer in that space may facilitate that the magnetic fields generated by these two transformers interact with each other. Furthermore, the anti-symmetric field cancellation provided by the second transformer may cancel out the first magnetic field.

In an example, the terminals 1011 and 1012 of the first transformer are configured to receive low band signals, while terminals 1021 and 1022 of the second transformer are configured for high band signals. In an example, the first primary winding 1001a and the second primary winding 1001b of the first transformer are positioned on either side of the secondary winding 1002c of the second transformer. Through such an overlapping configuration at this layer between the first primary winding 1001a and the second primary winding 1001b of the first transformer and the secondary winding 1002c of the second transformer may allow the magnetic fields generated by them to cancel out. For example, the secondary winding 1001c of the first transformer may be placed to overlap the first and second primary windings 1001a, 1001b to facilitate magnetic coupling for low band signals.

In an example, the secondary winding 1002c of the second transformer may be configured with an anti-symmetric design. The anti-symmetric configuration may include includes the upper section (first winding structure) and the lower section (second winding structure), which may be coupled to each other to form the complete secondary winding 1002c of the second transformer, such that they generate magnetic fields at opposite directions to counteract each other, for canceling magnetic interference with the first transformer. For example, the upper section of the secondary winding 1002c of the second transformer may overlap with the first primary winding 1002a of the second transformer, while the lower section may overlap with the second primary winding 1002b of the second transformer, forming complementary coupling pairs for high band signals.

In an example, the secondary winding 1002c may be characterized by a symmetrical arrangement, such that the lower section and the upper section are arranged in a symmetrical configuration relative to each other. In an example, the first primary winding 1002a and the second primary winding 1002b of the second transformer may be positioned symmetrically on either side of the secondary winding 1002c, aligning with the high band signals' respective polarities (e.g. positive for 1002a and negative for 1002b).

The secondary winding 1002c may be disposed within the two primary windings 1001a, 1001b of the first transformer and may be arranged in a mirrored configuration relative to these windings. This mirrored configuration may align the magnetic fields of the second transformer with the opposing fields of the first transformer. In an example, the first winding structure (i.e. the lower section) and the second winding structure (i.e. the upper section) of the secondary winding 1002c each may include input terminals, which are positioned on opposite sides of a first axis. For example, terminal 1021 of the first primary winding 1002a and terminal 1022 of the second primary winding 1002b may be located on opposite sides of the axis defined by the secondary winding 1002c.

Similarly, the first winding structure and the second winding structure of the secondary winding 1002c may each include output terminals, positioned on opposite sides of a second axis. For instance, terminal 1026 of the upper section (first winding structure) and terminal 1027 of the lower section (second winding structure) may be symmetrically positioned relative to the second axis, which may allow efficient signal transfer from the second transformer to the external components in the transmit chain.

In an example, the transmission circuit may further include at least one digital circuit and one control circuit to manage communication signals. These circuits may be implemented on the same substrate as the transformers to utilize the space-efficient overlapping configuration of the windings. The digital and control circuits may manage signal generation, modulation, and transmission, ensuring that the low band and high band signals are processed and transmitted. For example, the control circuit may modulate the low band signals transmitted through terminals 1011 and 1012 of the first transformer and the high band signals transmitted through terminals 1021 and 1022 of the second transformer. In accordance with various aspects described herein, the first transformer may be arranged to at least partially enclose the second transformer. The secondary winding 1001c of the first transformer may overlap with the windings of the second transformer.

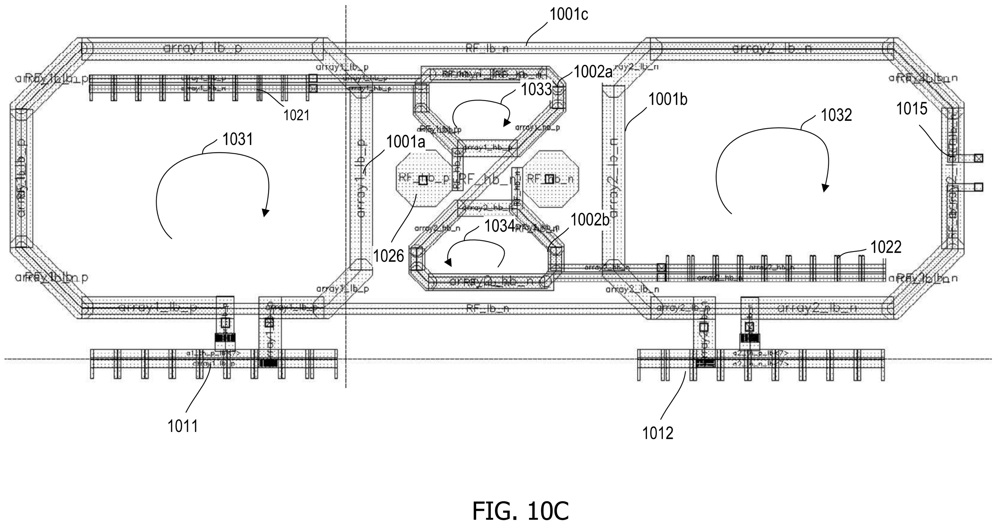

FIG. 10C illustrates the exemplary transmission circuit, in which the layers shown in FIGs. 10A and 10B are overlaid. The components depicted include: the first primary winding 1001a (array1_lb_p), the second primary winding 1001b (array2_lb_n), and the secondary winding 1001c (RF_lb_n) of the first transformer; the first primary winding 1002a (array1_hb_p), the second primary winding 1002b (array_hb_n), and the secondary winding 1002c (RF_hb_p, RF_hb_n) of the second transformer; terminals 1011 for the first low band inputs; terminals 1012 for the second low band inputs; terminals 1021 for the first high band inputs; terminals 1022 for the second high band inputs; terminals 1015 for the low band outputs; and the terminals 1026, 1026 for the high band outputs. The figure further illustrates the direction of the magnetic fields. As can be seen, the magnetic field 1031 generated at the side of the first primary winding 1001a (by the first primary winding 1001a) and the magnetic field 1032 generated at the side of the second primary winding (by the second primary winding 1001b), which may also be referred to as low band magnetic fields, are clockwise oriented (i.e. clockwise direction). On the other hand, the magnetic field 1033 generated at the side of the first primary winding 1002a (by the first primary winding 1002a; by the upper section of the secondary winding 1002c) is clockwise oriented, while the magnetic field 1034 generated at the side of the second primary winding (by the second primary winding 1002b; by the upper section of the secondary winding 1002c), is at counter-clockwise direction. This may also be referred to as high band magnetic fields are at opposite directions.

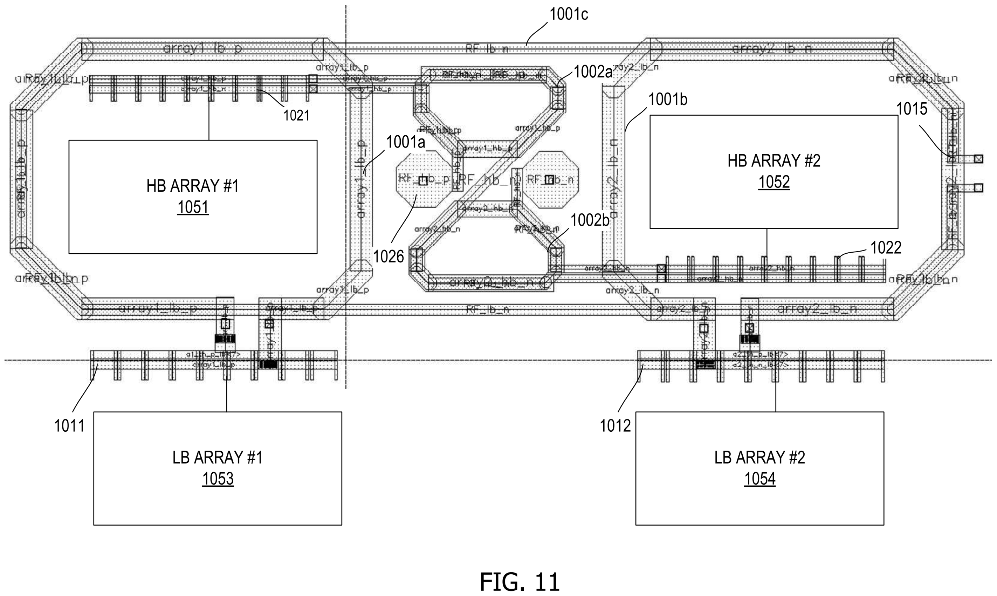

FIG. 11 shows an exemplary illustration of a transmission circuit in accordance with various aspects described herein. Illustratively, the transmission circuit depicted herein includes the transmission circuit depicted in FIGs. 10A-C. Continuing with respect to aspects described in accordance with FIGs. 10A-C, the transmission circuit may further include one or more circuits of at least one transmit path of an RF transceiver (e.g. the RF transceiver), such as: a first high band array 1051, a second high band array 1052, a first low band array 1053, and a second low band array 1054. The first high band array 1051 may provide a first high band signal (e.g. the high band signal described above) and the second high band array 1052 may provide a second high band signal (e.g. the further high band signal) to the second transformer via the terminals 1021 and 1022. The first low band array 1053 may provide a first low band signal (e.g. the low band signal described above) and the second low band array 1053 may provide a second low band signal (e.g. the further low band signal) to the first transformer via the terminals 1011 and 1012.

In an example, at least one transmit circuit, for example the first high band array 1051 and the second high band array 1052 may be disposed on a substrate. Considering the loops may be formed relative to a plane of the transmission circuit, by the first primary winding 1001a and the second primary winding 1001b of the first transformer, the first high band array 1051 and the second high band array 1052 may be disposed relative to the plane within these two loops respectively. The substrate on which the first high band array 1051 and the second high band array 1052 may be the same substrate with the substrate of the first layer or the second layer of the transmission circuit, or may be a substrate of a third layer that is above or below the first and the second layer of the transmission circuit. In an example, , these high band arrays 1051, 1052 may be placed inside the loops created by the first primary winding 1001a and the second primary winding 1001b of the first transformer. By placing the high band transmit circuits inside the low band transformer's loops, the circuit may efficiently utilize the substrate area, reducing the overall footprint and potentially lowering manufacturing costs.

The first high band array 1051 may include a first transmit circuit configured to provide the signal within the second frequency band (e.g. HB). Similarly, the second high band array 1052 may include a second transmit circuit also configured for high band signal transmission(n. These transmit circuits may include components such as digital power amplifiers (e.g. the digital power amplifiers 440a-b) and digital to time converters (e.g. the digital to time converters 430a-b), as described in accordance with FIG. 4 regarding one or more transmit paths of the RF transceiver. As illustrated herein, the first high band array 1051 and the second high band array 1052 may be disposed within the loops formed by the first primary winding 1001a and the second primary winding 1001b of the first transformer respectively. In other words, the first high band array 1051 and the second high band array 1052 may be housed within the loops formed by the first primary winding 1001a and the second primary winding 1001b. This configuration may allow a balanced signal transmission and reception within the high band to enhance overall efficiency of the transmission circuit.

The first low band array 1053 and the second low band array 1054 may further be disposed on a substrate outside of the loops formed by the first and second windings 1001a, 1001b of the first transformer. The substrate on which the first low band array 1053 and the second low band array 1054 may be the same substrate with the substrate of the first layer or the second layer of the transmission circuit, or may be a substrate of a further layer that is above or below the first and the second layer of the transmission circuit, or may be the substrate on which the first high band array 1051 and the second high band array 1052 are disposed. The first low band array 1053 and the second low band array 1054 may include further transmit circuits configured to provide signals within the first frequency band (e.g. LB). By placing the low band transmit circuits outside the loops, the transmission circuit may maintain separation between the high band and low band transmit circuits to reduce potential interference and simplify the circuit layout.

In an example, at least one further transmit circuit may include the first low band array 1053 and the second low band array 1053 disposed asymmetrically to the transmit circuits within the loops relative to an axis on the plane. The first low band array 1053 and the second low band array 1054 may be positioned asymmetrically relative to the high band arrays 1051 and 1052 along a defined axis on the substrate plane. This asymmetrical placement may enhance the performance by minimizing crosstalk and interference between the high band and low band transmit circuits. For example, if the axis is a central vertical line dividing the substrate, the high band arrays 1051 and 1052 may be symmetrically placed within the loops on either side of the axis, while the low band arrays 1053 and 1054 may be positioned outside the loops on opposite sides of the axis, but not symmetrically.

In an example, the first winding (first primary winding 1001a) and the second winding (second primary winding 1001b) are disposed on the substrate forming first and second loops, respectively. The high band transmit circuits within the first high band array 1051 and the second high band array 1052 are placed inside these loops. This placement allows the high band transmit circuits to be in close proximity to the second transformer, facilitating efficient magnetic coupling and signal transmission within the HB.

It is to be noted that in the practical implementation illustrated in FIG. 11, the first high band array 1051 and the second high band array 1052 are illustrated within the loops of the windings, indicating their placement on the substrate. The first low band array 1053 and the second low band array 1054 are shown outside the loops, illustrating the asymmetrical placement. Moreover, the free area below the second transformer part, which resides between the low band arrays 1053, 1054 may be utilized for digital and control circuits, as mentioned, which may illustratively include a digital front end (e.g. the digital front end 420), a high band and low band decoder. In some examples the digital to time converters may also be disposed in this area. This may facilitate an efficient use of space, which may allow additional circuitry to be integrated into the transmission circuit without increasing the substrate's size. These digital and control circuits may manage communication signals, modulate the low band and high band signals, and provide overall control of the transmission process, aligning with the functions described in the context information regarding the RF transceiver's transmit path.

In the context of an RF transceiver (e.g. the RF transceiver), the transmit circuits within the high band and low band arrays may correspond to components like digital power amplifiers and DTCs, which may process the amplitude modulation (AM) and phase modulation (PM) signals generated by the DFE. The digital front end may receive communication signals and convert them into polar signals, which may be then used by the transmit circuits to generate modulated RF signals in the respective frequency bands. The placement of these transmit circuits within and outside the loops may facilitate efficient signal processing and transmission, as well as effective coupling through the dual-band transformer.

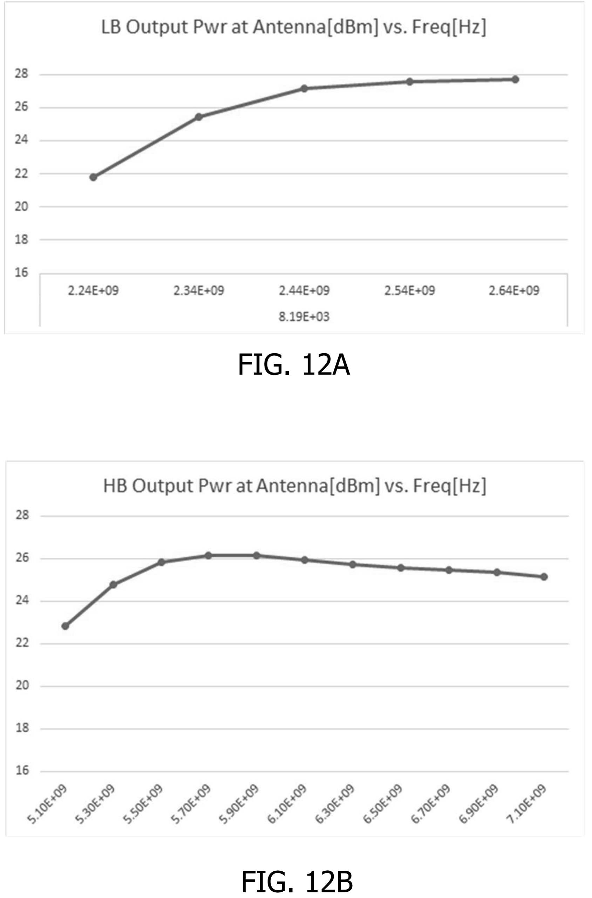

FIG. 12A illustrates measured output power levels at the antenna for the low band frequency range of an RF transceiver implementing the described diplexer circuit and transmission circuit. The graph depicts a gradual increase in power output with frequency, beginning at approximately 22 dBm at 2.24 GHz and peaking at nearly 28 dBm around 2.54 GHz. The curve demonstrates consistent power delivery across the low band range, indicating efficient coupling and minimal loss through the transmission path and diplexer.

FIG. 12B illustrates the corresponding output power levels for the high band frequency range under similar conditions. The output power increases sharply at lower frequencies, reaching a maximum of approximately 26 dBm near 5.5 GHz. Beyond this point, the power remains stable up to around 6.0 GHz, followed by a gradual decrease, settling near 24 dBm at 7.1 GHz. This behavior highlights the capability of the high band transmit chain to maintain effective power transfer over a wide frequency range.

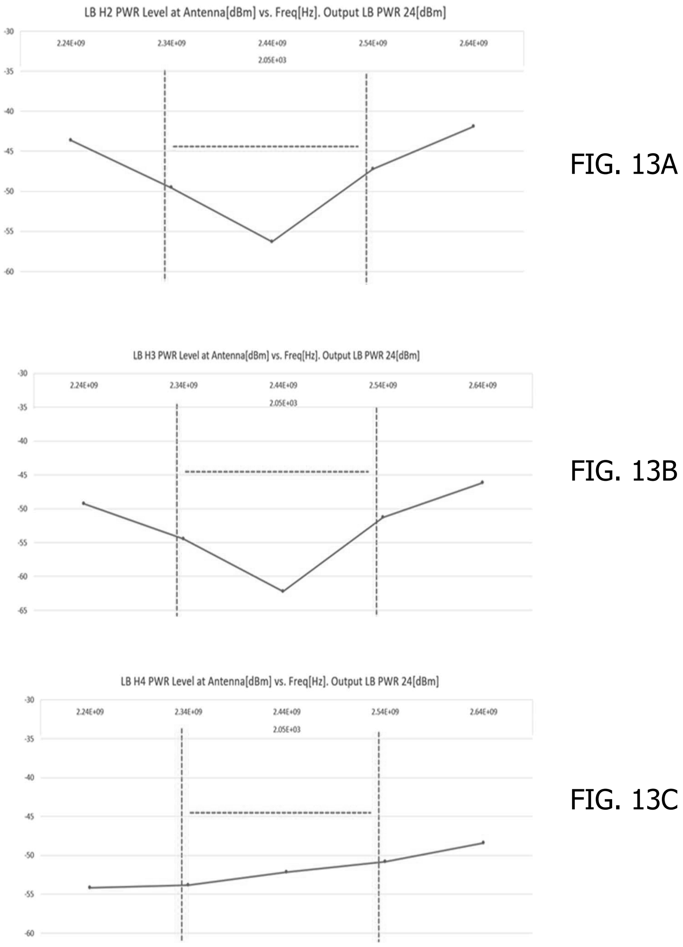

FIG. 13A shows second harmonic (H2) power levels at the antenna for the low band frequency band, with an low band fundamental frequency power level of 24 dBm in the context provided in FIGs. 12A and 12B. The graph indicates a consistent suppression of H2 across the frequency range, with power levels remaining significantly below -40 dBm. This demonstrates effective harmonic rejection, likely achieved through the optimized coupling and anti-symmetric design of the transmission circuit.

FIG. 13B illustrates the third harmonic (H3) power levels at the antenna under the same low band conditions in the context provided in FIGs. 12A and 12B. The H3 levels are further suppressed compared to H2, consistently remaining below -50 dBm across the frequency range. This enhanced suppression highlights the efficiency of the diplexer and transformer configuration in mitigating higher-order harmonics, ensuring spectral cleanliness.

FIG. 13C represents the fourth harmonic (H4) power levels at the antenna for the low band in the context provided in FIGs. 12A and 12B. The graph shows H4 levels below - 60 dBm, indicating even greater attenuation compared to H2 and H3. This substantial suppression underscores the system's capability to address higher harmonics effectively, further contributing to regulatory compliance and reduced interference. Together, these graphs validate the harmonic suppression capability of the described RF transceiver and transmission circuit.

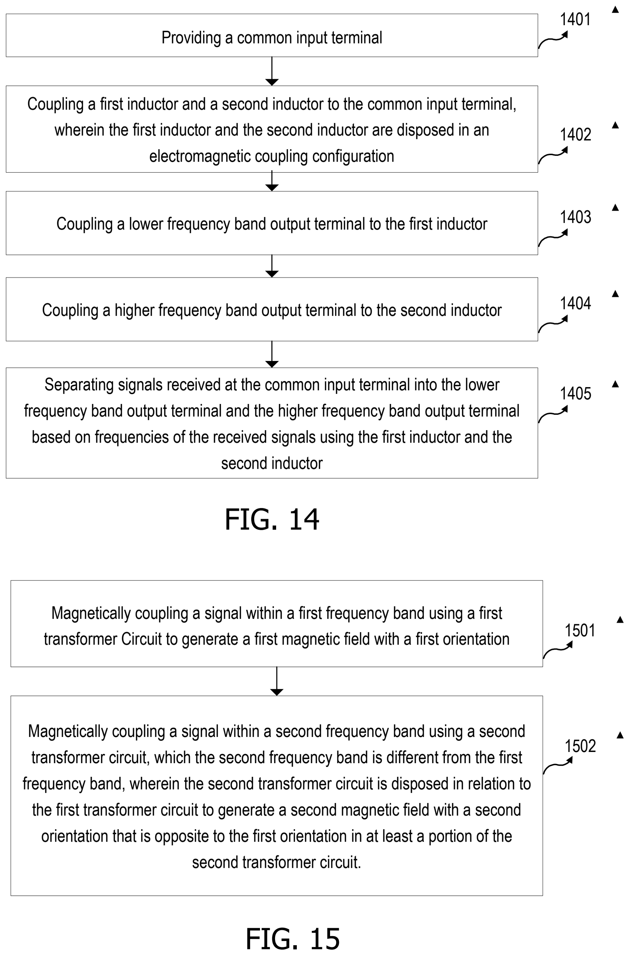

FIG. 14 shows an example of a method that may include: providing 1401 a common input terminal; coupling 1402 a first inductor and a second inductor to the common input terminal, wherein the first inductor and the second inductor are disposed in an electromagnetic coupling configuration; coupling 1403 a lower frequency band output terminal to the first inductor; coupling 1404 a higher frequency band output terminal to the second inductor; and separating 1405 signals received at the common input terminal into the lower frequency band output terminal and the higher frequency band output terminal based on frequencies of the received signals using the first inductor and the second inductor.

FIG. 15 shows an example of a method for a transmission circuit, the method may include: magnetically 1501 coupling a signal within a first frequency band using a first transformer circuit to generate a first magnetic field with a first orientation; and magnetically coupling 1502 a signal within a second frequency band using a second transformer circuit, which the second frequency band is different from the first frequency band, wherein the second transformer circuit is disposed in relation to the first transformer circuit to generate a second magnetic field with a second orientation that is opposite to the first orientation in at least a portion of the second transformer circuit.

The following examples pertain to further aspects described herein.

In example 1, the subject matter includes an apparatus including: a common input terminal; a first inductor and a second inductor, each coupled to the common input terminal, wherein the first inductor and the second inductor are disposed in an electromagnetic coupling configuration; a lower frequency band output terminal coupled to the first inductor; a higher frequency band output terminal coupled to the second inductor; wherein the first inductor and the second inductor are configured to separate signals received from the common input terminal into the lower frequency band output terminal and the higher frequency band output terminal based on frequencies of the received signals.

In example 2, the subject matter of example 1, wherein the first inductor and the second inductor are configured to direct a received signal of a first frequency band to the lower frequency band output terminal and a received signal of a second frequency band to the higher frequency band output terminal; wherein the first frequency band is lower than the second frequency band.

In example 3, the subject matter of example 1 or example 2, wherein the first inductor is positioned concentrically around the second inductor.

In example 4, the subject matter of any one of examples 1 to 3, wherein the second inductor forms a first loop and the first inductor forms a second loop on a plane; wherein at least one of the first inductor or the second inductor includes an input connector extending on the plane between the first loop and the second loop to connect to the common input terminal.

In example 5, the subject matter of example 4, wherein the first loop is an outer loop and the second loop is an inner loop disposed within an area on the plane enclosed by the first loop.

In example 6, the subject matter of example 4 or example 5, wherein the inner loop and the outer loop are separated by a predetermined spacing selected to achieve a desired coupling coefficient between the first inductor and the second inductor.

In example 7, the subject matter of any one of examples 1 to 6,wherein the first inductor and the second inductor are disposed on a substrate at a first layer; wherein at least one of the first inductor or the second inductor includes an output connector to couple the lower frequency band output terminal or the higher frequency band output terminal respectively; wherein the output connector extends at a second layer that is above or below the first layer.

In example 8, the subject matter of example 7, wherein the common input terminal is coupled to the first inductor and the second inductor via a common input connector disposed at the second layer.

In example 9, the subject matter of any one of examples 1 to 6, wherein the apparatus includes a first layer and a second layer that is above or below the first layer; wherein the first layer includes the first inductor and the second layer includes the second inductor.

In example 10, the subject matter of any one of examples 1 to 9, may further include: a first capacitor coupled to the first inductor and to first further diplexer components; and a second capacitor coupled to the second inductor and to second further diplexer components.

In example 11, the subject matter of any one of examples 1 to 10, may further include: a first ground terminal coupled to the first inductor through a first ground connection; and a second ground terminal coupled to the second inductor through a second ground connection.

In example 12, the subject matter of any one of examples 1 to 11, wherein the electromagnetic coupling configuration between the first inductor and the second inductor has a coupling coefficient selected to meet predetermined isolation and rejection specifications.

In example 13, the subject matter of any one of examples 1 to 12, wherein the diplexer circuit is integrated with at least one of a switch or a combiner on a single chip.

In example 14, the subject matter includes a transmission circuit including: a first transformer circuit configured to magnetically couple a signal within a first frequency band and generate a first magnetic field with a first orientation; a second transformer circuit configured to magnetically couple a signal within a second frequency band that is different from the first frequency band, wherein the second transformer circuit is disposed in relation to the first transformer circuit to generate a second magnetic field with a second orientation that is opposite to the first orientation in at least a portion of the second transformer circuit.

In example 15, the subject matter of example 14, wherein the first frequency band is a frequency band that is lower than the second frequency band.

In example 16, the subject matter of example 14 or 15, wherein the first transformer circuit includes a first winding and a second winding arranged on a plane; wherein second transformer circuit is disposed between the first winding and the second winding on the plane.

In example 17, the subject matter of example 16, wherein the first winding and the second winding are arranged to generate respective magnetic fields oriented in a same orientation that is opposite to the second orientation.

In example 18, the subject matter of example 16 or 17, wherein the first winding is disposed on a substrate forming a first loop; wherein the second winding is disposed on the substrate forming a second loop; wherein the transmission circuit includes at least one transmit circuit disposed on the substrate within at least one of the first loop or the second loop; wherein the at least one transmit circuit is configured to provide the signal within the second frequency band.

In example 19, the subject matter of example 18, wherein the at least one transmit circuit includes a first transmit circuit disposed on the substrate within the first loop and a second transmit circuit disposed on the substrate within the second loop.

In example 20, the subject matter of example 18 or example 19, wherein the transmission circuit further includes at least one further transmit circuit disposed on the substrate that is outside of the first loop or the second loop; wherein the at least one further transmit circuit is configured to provide the signal within the first frequency band.

In example 21, the subject matter of any one of examples 18 to 20, wherein the at least one further transmit circuit includes a first further transmit circuit and a second further transmit circuit disposed on the substrate asymmetrically to the at least one transmit circuit relative to an axis on the plane.

In example 22, the subject matter of any one of examples 14 to 21, wherein the second transformer circuit includes at least one of an 8-shaped, an S-shaped, or a Z-shaped winding.

In example 23, the subject matter of any one of examples 14 to 22, wherein the second transformer circuit includes a first winding structure and a second winding structure coupled to the first winding structure; wherein the first winding structure and the second winding structure are arranged in a symmetrical configuration relative to each other.

In example 24, the subject matter of example 23, wherein the first winding structure and the second winding structure of the second transformer circuit are disposed within two windings of the first transformer circuit and arranged in a mirrored configuration relative to each other.

In example 25, the subject matter of example 23 or 24, wherein the first winding structure includes a first input terminal; wherein the second winding structure includes a second input terminal; wherein the first input terminal and the second input terminal are disposed on opposite sides of a first axis between the first winding structure and the second winding structure.

In example 26, the subject matter of any one of examples 23 to 25, wherein the first winding structure includes a first output terminal; wherein the second winding structure includes a second output terminal; wherein the first output terminal and the second output terminal are disposed on opposite sides of a second axis between the first winding structure and the second winding structure.

In example 27, the subject matter of any one of examples 14 to 26, wherein the transmission circuit further includes at least one digital circuit and at least one control circuit configured to generate communication signals.

In example 28, the subject matter of any one of examples 14 to 27, wherein the first transformer circuit is arranged to at least partially enclose the first transformer circuit.

In example 29, the subject matter includes a method for a diplexer circuit, the method including: providing a common input terminal; coupling a first inductor and a second inductor to the common input terminal, wherein the first inductor and the second inductor are disposed in an electromagnetic coupling configuration; coupling a lower frequency band output terminal to the first inductor; coupling a higher frequency band output terminal to the second inductor; and separating signals received at the common input terminal into the lower frequency band output terminal and the higher frequency band output terminal based on frequencies of the received signals using the first inductor and the second inductor.

In example 30, the subject matter of example 29, may further include: directing a received signal of a first frequency band to the lower frequency band output terminal and a received signal of a second frequency band to the higher frequency band output terminal using the first inductor and the second inductor, wherein the first frequency band is lower than the second frequency band.

In example 31, the subject matter of example 29 or 30, may further include: positioning the first inductor concentrically around the second inductor.

In example 32, the subject matter of any one of examples 29 to 31, may further include: forming the second inductor as a first loop and the first inductor as a second loop on a plane; and providing an input connector extending on the plane between the first loop and the second loop to connect to the common input terminal for at least one of the first inductor or the second inductor.

In example 33, the subject matter of example 32, may further include: forming the first loop as an outer loop and the second loop as an inner loop disposed within an area on the plane enclosed by the first loop.

In example 34, the subject matter of example 32 or 33, may further include: separating the inner loop and the outer loop by a predetermined spacing selected to achieve a desired coupling coefficient between the first inductor and the second inductor.

In example 35, the subject matter of any one of examples 29 to 34, may further include: disposing the first inductor and the second inductor on a substrate at a first layer; coupling the lower frequency band output terminal or the higher frequency band output terminal to the first inductor or the second inductor, respectively, using an output connector; and extending the output connector at a second layer that is above or below the first layer.

In example 36, the subject matter of example 35, may further include: coupling the common input terminal to the first inductor and the second inductor via a common input connector disposed at the second layer.

In example 37, the subject matter of any one of examples 29 to 34, may further include: providing the first inductor on a first layer and the second inductor on a second layer that is above or below the first layer.

In example 38, the subject matter of any one of examples 29 to 37, may further include: coupling a first capacitor to the first inductor and to first further diplexer components; and coupling a second capacitor to the second inductor and to second further diplexer components.

In example 39, the subject matter of any one of examples 29 to 38, may further include: coupling a first ground terminal to the first inductor through a first ground connection; and coupling a second ground terminal to the second inductor through a second ground connection.

In example 40, the subject matter of any one of examples 29 to 39, may further include: selecting a coupling coefficient for the electromagnetic coupling configuration between the first inductor and the second inductor to meet predetermined isolation and rejection specifications.

In example 41, the subject matter of any one of examples 29 to 40, may further include: integrating the diplexer circuit with at least one of a switch or a combiner on a single chip.

In example 42, the subject matter includes a method for a transmission circuit, the method including: magnetically coupling a signal within a first frequency band using a first transformer circuit to generate a first magnetic field with a first orientation; and magnetically coupling a signal within a second frequency band using a second transformer circuit that is different from the first frequency band, , wherein the second transformer circuit is disposed in relation to the first transformer circuit to generate a second magnetic field with a second orientation that is opposite to the first orientation in at least a portion of the second transformer circuit.

In example 43, the subject matter of example 42, wherein the first frequency band is lower than the second frequency band.

In example 44, the subject matter of example 42 or 43, may further include: arranging the first transformer circuit with a first winding and a second winding on a plane; and providing the second transformer circuit between the first winding and the second winding on the plane.

In example 45, the subject matter of example 44, may further include: arranging the first winding and the second winding to generate respective magnetic fields oriented in a same orientation that is opposite to the second orientation.

In example 46, the subject matter of example 44 or 45, may further include: disposing the first winding on a substrate to form a first loop; disposing the second winding on the substrate to form a second loop; disposing at least one transmit circuit on the substrate within at least one of the first loop or the second loop; and configuring the at least one transmit circuit to provide the signal within the second frequency band.

In example 47, the subject matter of example 46, may further include: disposing a first transmit circuit on the substrate within the first loop; and disposing a second transmit circuit on the substrate within the second loop.

In example 48, the subject matter of example 46 or 47, may further include: disposing at least one further transmit circuit on the substrate outside of the first loop or the second loop; and configuring the at least one further transmit circuit to provide the signal within the first frequency band.

In example 49, the subject matter of any one of examples 46 to 48, may further include: disposing a first further transmit circuit and a second further transmit circuit asymmetrically to the at least one transmit circuit relative to an axis on the plane.

In example 50, the subject matter of any one of examples 42 to 49, may further include: configuring the second transformer circuit with at least one of an 8-shaped, an S-shaped, or a Z-shaped winding.

In example 51, the subject matter of any one of examples 42 to 50, may further include: coupling a first winding structure of the second transformer circuit to a second winding structure of the second transformer circuit; and arranging the first winding structure and the second winding structure in a symmetrical configuration relative to each other.

In example 52, the subject matter of example 51, may further include: providing the first winding structure and the second winding structure of the second transformer circuit within two windings of the first transformer circuit; and arranging the first winding structure and the second winding structure in a mirrored configuration relative to each other.

In example 53, the subject matter of example 51 or 52, may further include: providing a first input terminal for the first winding structure; providing a second input terminal for the second winding structure; and positioning the first input terminal and the second input terminal on opposite sides of a first axis between the first winding structure and the second winding structure.

In example 54, the subject matter of any one of examples 51 to 53, may further include: providing a first output terminal for the first winding structure; providing a second output terminal for the second winding structure; and positioning the first output terminal and the second output terminal on opposite sides of a second axis between the first winding structure and the second winding structure.

In example 55, the subject matter of any one of examples 42 to 54, may further include: generating communication signals using at least one digital circuit and at least one control circuit.

In example 56, the subject matter of any one of examples 42 to 55, may further include: arranging the first transformer circuit to at least partially enclose the second transformer circuit. The word "exemplary" is used herein to mean "serving as an example, instance, or illustration". Any embodiment or design described herein as "exemplary" is not necessarily to be construed as preferred or advantageous over other embodiments or designs.

The words "plurality" and "multiple" in the description or the claims expressly refer to a quantity greater than one. The terms "group (of)", "set [of]", "collection (of)", "series (of)", "sequence (of)", "grouping (of)", etc., and the like in the description or in the claims refer to a quantity equal to or greater than one, i.e. one or more. Any term expressed in plural form that does not expressly state "plurality" or "multiple" likewise refers to a quantity equal to or greater than one.

Any vector and/or matrix notation utilized herein is exemplary in nature and is employed solely for purposes of explanation. Accordingly, the apparatuses and methods of described herein accompanied by vector and/or matrix notation are not limited to being implemented solely using vectors and/or matrices, and that the associated processes and computations may be equivalently performed with respect to sets, sequences, groups, etc., of data, observations, information, signals, samples, symbols, elements, etc.

As used herein, "memory" is understood as a non-transitory computer-readable medium in which data or information can be stored for retrieval. References to "memory" included herein may thus be understood as referring to volatile or non-volatile memory, including random access memory ("RAM"), read-only memory ("ROM"), flash memory, solid-state storage, magnetic tape, hard disk drive, optical drive, etc., or any combination thereof. Furthermore, registers, shift registers, processor registers, data buffers, etc., are also embraced herein by the term memory. A single component referred to as "memory" or "a memory" may be composed of more than one different type of memory, and thus may refer to a collective component including one or more types of memory. Any single memory component may be separated into multiple collectively equivalent memory components, and vice versa. Furthermore, while memory may be depicted as separate from one or more other components (such as in the drawings), memory may also be integrated with other components, such as on a common integrated chip or a controller with an embedded memory.

The term "software" refers to any type of executable instruction, including firmware.

In the context described herein, the term "process" may be used, for example, to indicate a method. Illustratively, any process described herein may be implemented as a method (e.g., a channel estimation process may be understood as a channel estimation method). Any process described herein may be implemented as a non-transitory computer readable medium including instructions configured, when executed, to cause one or more processors to carry out the process (e.g., to carry out the method).

Throughout the drawings, it should be noted that like reference numbers are used to depict the same or similar elements, features, and structures, unless otherwise noted. It should be noted that certain components may be omitted for the sake of simplicity. It should be noted that nodes (dots) are provided to identify the circuit line intersections in the drawings including electronic circuit diagrams.

The phrase "at least one" and "one or more" may be understood to include a numerical quantity greater than or equal to one (e.g., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. For instance, the phrase "a plurality" may be understood to include a numerical quantity greater than or equal to two (e.g., two, three, four, five, [...], etc.).

As used herein, a signal or information that is "indicative of", "representative", "representing", or "indicating" a value or other information may be a digital or analog signal that encodes or otherwise, communicates the value or other information in a manner that can be decoded by and/or cause a responsive action in a component receiving the signal. The signal may be stored or buffered in computer-readable storage medium prior to its receipt by the receiving component and the receiving component may retrieve the signal from the storage medium. Further, a "value" that is "indicative of "or "representative" some quantity, state, or parameter may be physically embodied as a digital signal, an analog signal, or stored bits that encode or otherwise communicate the value.

As used herein, a signal may be transmitted or conducted through a signal chain in which the signal is processed to change characteristics such as phase, amplitude, frequency, and so on. The signal may be referred to as the same signal even as such characteristics are adapted. In general, so long as a signal continues to encode the same information, the signal may be considered as the same signal. For example, a transmit signal may be considered as referring to the transmit signal in baseband, intermediate, and radio frequencies.

The terms "processor" or "controller" as, for example, used herein may be understood as any kind of technological entity that allows handling of data. The data may be handled according to one or more specific functions executed by the processor. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, central processing unit (CPU), graphics processing unit (GPU), digital signal processor (DSP), field programmable gate array (FPGA), integrated circuit, application specific integrated circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

The terms "one or more processors" is intended to refer to a processor or a controller. The one or more processors may include one processor or a plurality of processors. The terms are simply used as an alternative to the "processor" or "controller".

The term "user device" is intended to refer to a device of a user (e.g. occupant) that may be configured to provide information related to the user. The user device may exemplarily include a mobile phone, a smart phone, a wearable device (e.g. smart watch, smart wristband), a computer, etc.

As utilized herein, terms "module", "component," "system," "circuit," "element," "slice," " circuit," and the like are intended to refer to a set of one or more electronic components, a computer-related entity, hardware, software (e.g., in execution), and/or firmware. For example, circuit or a similar term can be a processor, a process running on a processor, a controller, an object, an executable program, a storage device, and/or a computer with a processing device. By way of illustration, an application running on a server and the server can also be circuit. One or more circuits can reside within the same circuit, and circuit can be localized on one computer and/or distributed between two or more computers. A set of elements or a set of other circuits can be described herein, in which the term "set" can be interpreted as "one or more".

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art. The term "data item" may include data or a portion of data.

It will be understood that when an element is referred to as being "connected" or "coupled" to another element, it can be physically connected or coupled to the other element such that current and/or electromagnetic radiation (e.g., a signal) can flow along a conductive path formed by the elements. Inherently, such element is connectable or couplable to the another element. Intervening conductive, inductive, or capacitors may be present between the element and the other element when the elements are described as being coupled or connected to one another. Further, when coupled or connected to one another, one element may be capable of inducing a voltage or current flow or propagation of an electro-magnetic wave in the other element without physical contact or intervening components. Further, when a voltage, current, or signal is referred to as being "provided" to an element, the voltage, current, or signal may be conducted to the element by way of a physical connection or by way of capacitive, electro-magnetic, or inductive coupling that does not involve a physical connection.

Unless explicitly specified, the term "instance of time" refers to a time of a particular event or situation according to the context. The instance of time may refer to an instantaneous point in time, or to a period of time which the particular event or situation relates to.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as RF transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/formula/relationship and 'indirect' calculations via lookup or hash tables and other array indexing or searching operations.

While the above descriptions and connected figures may depict electronic device components as separate elements, skilled persons will appreciate the various possibilities to combine or integrate discrete elements into a single element. Such may include combining two or more circuits to form a single circuit, mounting two or more circuits onto a common chip or chassis to form an integrated element, executing discrete software components on a common processor core, etc. Conversely, skilled persons will recognize the possibility to separate a single element into two or more discrete elements, such as splitting a single circuit into two or more separate circuits, separating a chip or chassis into discrete elements originally provided thereon, separating a software component into two or more sections and executing each on a separate processor core, etc.

It is appreciated that implementations of methods detailed herein are demonstrative in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method. All acronyms defined in the above description additionally hold in all claims included herein.

## Claims

1. An apparatus comprising:
a common input terminal;
a first inductor and a second inductor, each coupled to the common input terminal, wherein the first inductor and the second inductor are disposed in an electromagnetic coupling configuration;
a lower frequency band output terminal coupled to the first inductor; and
a higher frequency band output terminal coupled to the second inductor;
wherein the first inductor and the second inductor are configured to separate signals received from the common input terminal into the lower frequency band output terminal and the higher frequency band output terminal based on frequencies of the received signals.

2. The apparatus of claim 1,
wherein the first inductor and the second inductor are configured to direct a received signal of a first frequency band to the lower frequency band output terminal and a received signal of a second frequency band to the higher frequency band output terminal; and
wherein the first frequency band is lower than the second frequency band.

3. The apparatus of any one of claims 1 or 2, wherein the first inductor is disposed concentrically around the second inductor.

4. The apparatus of any one of claims 1 to 3, wherein the second inductor forms a first loop and the first inductor forms a second loop on a plane; and
wherein at least one of the first inductor or the second inductor comprises an input connector extending on the plane between the first loop and the second loop to connect to the common input terminal.

5. The apparatus of claim 4,
wherein the first loop comprises an outer loop and the second loop comprises an inner loop disposed within an area on the plane enclosed by the first loop.

6. The apparatus of claim 5, wherein the inner loop and the outer loop are separated by a predetermined spacing selected to achieve a predefined coupling coefficient between the first inductor and the second inductor.

7. The apparatus of any one of claims 1 to 6, wherein the first inductor and the second inductor are disposed on a substrate at a first layer;
wherein at least one of the first inductor or the second inductor comprises an output connector to couple to the lower frequency band output terminal or the higher frequency band output terminal; and
wherein the output connector extends at a second layer that is above or below the first layer.

8. The apparatus of any one of claims 1 to 7, further comprising a first layer and a second layer that is above or below the first layer; and
wherein the first layer comprises the first inductor and the second layer comprises the second inductor.

9. The apparatus of any one of claims 1 to 8, further comprising:
a first capacitive circuitry coupled to the first inductor and to first further diplexer circuitry; and
a second capacitive circuitry coupled to the second inductor and to second further diplexer circuitry.

10. The apparatus of any one of claims 1 to 9, wherein the apparatus is integrated with at least one of a switch or a combiner on a single chip.

11. A method comprising:
providing a common input terminal;
coupling a first inductor and a second inductor to the common input terminal, wherein the first inductor and the second inductor are disposed in an electromagnetic coupling configuration;
coupling a lower frequency band output terminal to the first inductor;
coupling a higher frequency band output terminal to the second inductor; and separating signals received at the common input terminal into the lower frequency band output terminal and the higher frequency band output terminal based on frequencies of the received signals using the first inductor and the second inductor.

12. The method of claim 11, further comprising:
directing a received signal of a first frequency band to the lower frequency band output terminal and a received signal of a second frequency band to the higher frequency band output terminal using the first inductor and the second inductor, wherein the first frequency band is lower than the second frequency band.

13. The method of any one of claims 11 or 12, further comprising:
positioning the first inductor concentrically around the second inductor.

14. The method of any one of claims 11 to 13, further comprising:
forming the second inductor as a first loop and the first inductor as a second loop on a plane; and providing an input connector extending on the plane between the first loop and the second loop to connect to the common input terminal for at least one of the first inductor or the second inductor.

15. The method of any one of claims 11 to 14, further comprising:
disposing the first inductor and the second inductor on a substrate at a first layer; coupling the lower frequency band output terminal or the higher frequency band output terminal to the first inductor or the second inductor, respectively, using an output connector; and extending the output connector at a second layer that is above or below the first layer.
